# EUROPEAN PATENT APPLICATION

(11) **EP 1 500 945 A2**
(43) Date of publication of application: **26.01.2005**
(21) Application number: 04017337.9
(22) Date of filing: 22.07.2004
(51) Int. Cl.: G01R 33/36, H01M 10/42, H01M 10/48

(54) **Methods and devices for diagnosing the condition of rechargeable batteries**

(30) Priority: 22.07.2003 JP 2003199717; 18.02.2004 JP 2004040849
(71) Applicant: MAKITA CORPORATION, Anjo-shi, Aichi 446-8502 (JP)
(72) Inventor: Kazuyuki, Sakakibara, Anjo-shi Aichi 446-8502 (JP); Masaaki, Fukumoto, Anjo-shi Aichi 446-8502 (JP)
(74) Representative: Kramer Barske Schmidtchen

(57) **Abstract**

A diagnostic technique for determining whether the degradation of a rechargeable battery (18; 302) is normal or abnormal is provided. A device (2; 320) for determining whether the degradation of the rechargeable battery is normal or abnormal comprises a device (92, 94; 321, 338) for measuring one or more degradation indicators of the rechargeable battery, a device (72; 321) for determining the usage quantity of the rechargeable battery, and a device (72; 321, 334) for comparing the usage quantity with a reference usage quantity in the case where the measured degradation indicator exceeds a reference degradation value.

## Description

The present invention generally relates to techniques for diagnosing rechargeable batteries capable of repeatedly undergoing discharging/recharging cycles. Techniques for collecting information useful to diagnose rechargeable batteries are also provided.

A variety of cordless electrical equipment, such as mobile telephones, notebook computers, cordless vacuum cleaners, and cordless power tools, etc., utilize rechargeable batteries as their power source. If the cordless electrical equipment malfunctions, it is useful to know if the fault lies with the electrical equipment or with the rechargeable battery.

Further, if industrial goods, such as automobiles or computers, are manufactured in a mass production line by using a power tool powered by a rechargeable battery, it may be possible, e.g., that the tightening torque of the power tool becomes insufficient or an assigned operation cannot be completed within an allotted time frame, if a deteriorated rechargeable battery is used. In such cases, it would be advantageous to identify whether the condition of a battery has degraded beyond a permissible level (i.e., irreparable degradation).

Rechargeable batteries have a common characteristic that the internal resistance increases abruptly as the degradation progresses. Japanese Laid-Open Patent Publication No. 2000-223164 discloses a device that measures the internal resistance of a battery and compares the measured resistance with a reference value to diagnose whether the degradation has progressed.

The charging/discharging capacity of rechargeable batteries also has a common characteristic of decreasing abruptly as the degradation of the batteries progresses. Japanese Laid-Open Patent Publication No. H11-233162 discloses a device that measures the charging/discharging capacity of a battery and compares the measured capacity with a reference value to diagnose whether the degradation has progressed.

A charging device capable of counting the number of charging operations of a rechargeable battery also is known. When a battery that has already been charged a prescribed (predetermined) number of times is coupled to the charging device for recharging, this information is indicated to the operator, thus advising the battery user that degradation of the battery has progressed. The same charging device may charge two or more batteries. For example, Japanese Laid-Open Patent Publication No. H10-66266 discloses a technique wherein batteries are each provided with an ID and the number of charging operations for each battery is counted with reference to the battery ID.

The above-described known battery diagnosing devices are only capable of determining the end result, i.e. whether a battery has or has not degraded to a permissible level. Rechargeable batteries have the characteristic of degrading as they are used, and such degradation cannot be avoided. However, abrupt or rapid degradation may be caused by the manner of use of the rechargeable batteries. For example, the rechargeable battery will rapidly degrade if it is repeatedly over-discharged. Also, when the battery is charged too rapidly, the battery temperature during charging becomes too high, thereby causing the battery to degrade more rapidly than usual. In the prior art, because it was only possible to diagnose the end result, it has not been possible to obtain useful information for determining whether the end result was caused by normal or unavoidable degradation, or caused by abnormally rapid degradation due to an inappropriate (sub-optimal) manner of use or the like.

If the information necessary to determine whether the degradation was normal or abnormal is not obtained, it is not possible to objectively determine whether the manner of use of the battery must be improved, whether the life of the battery can be lengthened by improving the manner of use thereof, whether the battery has degraded normally and must be replaced, etc. When a battery rapidly degrades, battery users tend to assume that the rapid degradation was due to poor battery quality. Moreover, if users incorrectly believe that even normal batteries suffer from problems of quality, the desire to use rechargeable batteries and battery powered devices will be reduced. For this reason, useful information for determining whether batteries have degraded normally or abnormally should be obtained and preferably provided to the user so as to increase product satisfaction. The information indicating whether the battery has degraded normally or abnormally can also be advantageously utilized before the battery has degraded to the permissible level, e.g., by enabling the battery user to modify the manner in which the battery is used, as will be further discussed below.

It is, thus, an object of the present invention to provide techniques for diagnosing whether degradation of a rechargeable battery occurred normally or abnormally. In further developments of the present teachings, information collecting techniques for this purpose are also provided. In the present teachings, the terms "abnormal degradation" and "abnormally degrading" are intended to include situations in which the operational condition of the battery has been worsened (degraded) at a rate that is faster than would have been expected if a normal (i.e., defect-free) battery had been operated according to a normal or optimal manner of use. However, the meanings of these terms are not limited to such situations and skilled persons will appreciate that other situations may lead to the abnormal degradation of a rechargeable battery.

According to the above-described known battery diagnosing techniques, it was only possible to determine the end result, i.e. whether a battery has or has not degraded to a limit level. As a result, it was not possible to diagnose whether the degradation has progressed normally or abnormally before the degradation reached the limit level.

In order to overcome this problem of the known art, one embodiment of the present teachings provides a technique for diagnosing whether the battery degradation is progressing normally or abnormally. If abnormal progress of the degradation is determined before the battery has degraded to the limit level (i.e., irreparable degradation), the battery user may be informed that the manner of use of the battery is problematic, and the degradation speed (rate) of the battery may be slowed down by improving (modifying) the manner of use.

Moreover, according to known techniques, it was not possible to diagnose how much a rechargeable battery can be further used until the degradation thereof reaches the limit level. Instead, it was only possible to diagnose whether a battery had degraded to the limit level or not. Thus, rechargeable battery users could not, e.g., adequately plan for the need to replace a rechargeable battery that is approaching the end of its operational life and/or modify the manner of battery use in order to maximize the remaining operational life of the rechargeable battery.

In order to overcome this problem of the known art, another aspect of the present teachings provides a technique for estimating (predicting) how much future (remaining) use of the rechargeable battery may be possible until the degradation has progressed to the limit (permissible) level (irreparably degraded) at which further use of the battery must be halted in order to avoid possible damage to the electrical equipment that is driven by the battery.

In one embodiment of this aspect, battery diagnostic devices of the present teachings preferably determine whether a rechargeable battery has degraded normally or abnormally. For example, the device may preferably determine whether the battery has degraded normally or abnormally when one or more degradation indicator(s) has (have) reached a permissible (threshold) level. However, the device may also preferably determine whether the battery has degraded normally or abnormally before the degradation reaches the permissible level.

The device may comprise at least one detector (means) for measuring at least one degradation indicator representative of the degradation condition of the rechargeable battery, at least one means for determining the usage quantity (amount) of the battery, and a computer (e.g., a processor) for comparing the set of the measured degradation indicator and the determined (detected) usage quantity with a set of a reference degradation value and a reference usage value. The reference values are preferably determined based upon a relationship between changes of the degradation indicator as the usage quantity (amount) of the rechargeable battery increases, when the rechargeable battery is being used in a normal (or optimal) manner.

When a normal battery is used in the normal (e.g., optimal and/or intended) manner, the degradation indicator(s) of the battery increase(s) (or decrease(s), depending upon the degradation indicator) as the usage quantity of the battery increases according to standard (normal) relationship. When the degradation indicator is plotted with respect to the usage quantity on a two dimensional chart (map), in which the vertical axis represents the degradation indicator and the horizontal axis represents the usage quantity, the value of the degradation indicator increases along a standard (normal) curve (under normal conditions of use) relative to the increase of the usage quantity. Thus, the standard (normal) curve provides pairs of reference degradation values and reference usage values. That is, a set of reference degradation values is correlated to a set of reference usage values, so that the normal or expected value for the degradation indicator with respect to each particular usage quantity is provided.

If the measured degradation indicator and the determined usage quantity of a battery are equal, respectively, to the reference degradation value and the reference usage value (which may be predetermined for the battery), then it is determined that the battery is normal (i.e., defect-free) and has been used in a normal (or optimal) manner. However, if the measured degradation indicator is higher than the reference degradation value for a particular (measured) usage quantity, then it is determined that the degradation has progressed more rapidly than normal (optimal). On the other hand, if the determined usage quantity is larger than the reference usage value for a particular (measured) degradation value, then it is determined that the degradation has progressed more slowly than normal. Naturally, if the value of the degradation indicator decreases as degradation progresses, then a measured degradation indicator that is less than the reference degradation value for a particular battery usage quantity (i.e., amount of battery usage) will also indicate abnormal degradation.

In a further embodiment of this aspect, an "endpoint" reference degradation value is set to be the expected value of the measured degradation indictor when the battery has become irreparably degraded. In addition, the expected usage quantity when the battery has become irreparably degraded is set as an "endpoint" reference usage value. In this embodiment, the determined usage quantity is compared with the endpoint reference usage value after the measured degradation indicator has exceeded the end point reference degradation value. If the determined usage quantity is larger (greater) than the end point reference usage value, then it is determined that the degradation has progressed more slowly than normal. If the determined usage quantity is smaller (less) than the end point reference usage value, then it is determined that the degradation has progressed more rapidly than normal. Again, if the value of the degradation indicator decreases as degradation progresses, then these relationships would be inverted.

In another embodiment of this aspect, the reference degradation value may be less than the permissible level of the battery. In this embodiment, the determined usage quantity may be compared with the reference usage value associated with the reference degradation value that is equal to the measured degradation indicator. If the determined usage quantity is larger (greater) than the reference usage value, then it is determined that the degradation has progressed more slowly than normal. If the determined usage quantity is smaller (less) than the reference usage value, then it is determined that the degradation has progressed more rapidly than normal or optimal. In the alternative, the measured degradation indicator may be compared with the reference degradation value associated with the reference usage value that is equal to the determined usage quantity. If the measured degradation indicator is higher (greater) than the reference degradation value, then it is determined that the degradation has progressed more rapidly than normal. If the measured degradation indicator is lower (less) than the reference degradation value, then it is determined that the degradation has progressed more slowly than normal.

In this case, when the reference degradation value is the lower limit of the measured degradation indicator indicating irreparable degradation, the phrase 'the measured degradation indicator has exceeded the reference degradation value' refers to the measured degradation indicator falling below the reference degradation value. On the other hand, if the reference degradation value is the upper limit of the measured degradation indicator indicating irreparable degradation, the phrase 'the measured degradation indicator has exceeded the reference degradation value' refers to the measured degradation indicator rising above the reference degradation value.

As was briefly discussed above, it should again be noted that the present teachings are not particularly limited to measured degradation indicators that increase with usage quantity increases, as the measured degradation indicator(s) may also decrease with increases of the usage quantity.

According to the present teachings, it is possible to determine whether the rechargeable battery has degraded to a limit (threshold) level by measuring one or more degradation indicators that change in a manner that is reflective of the degradation condition of the rechargeable battery, and then comparing the measured degradation indicator(s) with the reference (predetermined) degradation value(s). In other words, degradation indicators are selected that can be utilized to reliably predict the present condition of the battery, as well as how much the battery can be further used (e.g., discharged and recharged) before the battery will no longer be operational.

In this device, in addition to the above, the usage quantity (amount) of the rechargeable battery is preferably determined, and when the measured degradation indicator has exceeded the reference degradation value, the determined usage quantity of the rechargeable battery is compared with the reference (predetermined) usage quantity for the measured degradation value. The reference usage quantity may be empirically determined based upon usage of normal rechargeable batteries. For example, the value(s) of one or more degradation indicator(s) of normal (i.e., defect-free) rechargeable batteries will typically change or progress according to a normal pattern, and will typically exceed the reference degradation value at a certain usage quantity. Thus, the average usage quantity at which the degradation indicator of the normal rechargeable batteries exceeds the reference degradation value may be utilized as the reference usage value. If the rechargeable battery is determined to have already been irreparably degraded when its usage quantity was less than the reference usage quantity, it can be deduced that the degradation progressed abnormally (faster than normal or optimal) and the manner of use of the rechargeable battery was possibly problematic. In this case, by modifying the manner of use, premature degradation of the rechargeable batteries may be prevented or minimized. On the other hand, if the rechargeable battery is determined to have degraded beyond further usage when its usage quantity (amount) was longer (greater) than the reference usage quantity, it can be determined that the degradation has progressed normally, there was not a problem in the manner of use, and the rechargeable battery did not have defects or quality problems.

In another embodiment of the present teachings, methods for diagnosing the condition of a rechargeable battery may include the steps of (i) measuring one or more degradation indicators representative of the degradation condition of the rechargeable battery, (ii) determining a usage quantity (amount) of the rechargeable battery, and (iii) comparing the combination of the measured degradation indicator and the determined usage quantity with a combination of a reference degradation value and a reference usage value.

According to the above-described device and method, it is possible to determine whether the battery has degraded normally or abnormally, and if the battery condition is degrading abnormally, appropriate countermeasures, etc. can be adopted in order to lengthen the operational lifetime of the battery.

In another aspect of the present teachings, methods and devices are provided for determining whether the condition of a rechargeable battery currently being used is degrading normally or abnormally. That is, it is possible to determine whether the battery condition is changing according to a normal degradation pattern or an abnormal degradation pattern.

According to this aspect of the present teachings, it can be determined whether the manner of use may be continued unchanged, or whether degradation will occur within an abnormally short period unless the manner of use, etc. is changed.

One such battery diagnosing device preferably comprises one or more devices for measuring one or more degradation indicators of the rechargeable battery, a device for determining a usage quantity (amount) of the rechargeable battery, a device for storing a reference degradation map, such as a two-dimensional map plotting the degradation indicator(s) with respect the usage quantity, and which map is preferably divided into a "normally degrading" region and an "abnormally degrading" region, and a device for determining whether the measured degradation indicator(s) and the determined usage quantity fall within the "normally degrading" region or the "abnormally degrading" region of the reference degradation map.

Research by the present inventors has ascertained that, when a pair of values consisting of the measured degradation indicator and the determined usage quantity is plotted on the two-dimensional map, certain pairs of values will fall within one region when a normal rechargeable battery is used normally and other pairs of values will fall within another region when the rechargeable battery is utilized according an inappropriate (less than optimal) manner of use. Therefore, this information has been utilized in the present teachings to generate maps or relationships between the amount of usage of the rechargeable batteries and various degradation indicators.

According to this aspect of the present teachings, the one or more degradation indicator(s) and the usage quantity of the rechargeable battery are detected, and it is determined whether the pair of values falls within the "normally degrading" region or the "abnormally degrading" region of the two dimensional map. By this means, it is possible to determine whether the rechargeable battery is degrading normally or abnormally. Similar to the above described embodiments, appropriate corrective action can be taken if the battery is determined to be abnormally degrading.

In this aspect of the present teachings, a method is also presented for determining whether the rechargeable battery is degrading normally or abnormally. This method preferably comprises the steps of: (i) measuring one or more degradation indicator(s) of the rechargeable battery, (ii) determining the usage quantity of the rechargeable battery, and (iii) determining whether the pair of the measured degradation indicator and the determined usage quantity falls within the "normally degrading" region or the "abnormally degrading" region of a stored reference degradation map. The reference degradation map may be predetermined (e.g., empirically) and stored in advance of performance of this method. The reference degradation map may be a two-dimensional map of the degradation indicator plotted with respect the usage quantity, which map is divided into at least the "normally degrading" and "abnormally degrading" regions, which respective regions may be determined empirically. Further, if two or more degradation indicators are detected, two or more reference maps, each plotted with respect to battery usage quantities, may be stored for use with the present method.

In the following description, it should be understood that the maps of the present teachings may be implemented as look up tables (LUTs), wherein two-dimensional maps have two "indices" for looking up values stored in the map. Thus, the degradation indicators and battery usage quantities, respectively, are representative examples of indices for such LUTs. As a result, the terms "maps" and "LUTs" are intended to be interchangeable herein.

Furthermore, while reference maps are a preferred embodiment, e.g., for storing a relationship between the degradation indicators and the battery usage quantity (amount) or between two different degradation indicators, other forms for representing such relationships may be utilized in accordance with the present teachings, such as for example equations for calculating a "normal" value for the degradation indicator based upon the amount of use of the battery. The present teachings are not particularly limited in this regard.

The above embodiments have provided devices and methods for determining whether the degradation condition of the rechargeable battery is progressing normally or abnormally based upon detected degradation indicators and usage quantities. However, in further developments of the present teachings, it is also possible to estimate a future or remaining battery usage quantity (amount). The term "future (remaining) usage quantity" is intended to mean how much the rechargeable battery may be used until the degradation thereof proceeds to a prescribed level. For example, in one representative embodiment of this aspect of the present teachings, the future (remaining) usage quantity may be the remaining number of times that the battery may be discharged/recharged before the battery is expected to become no longer operational (i.e., irreparably degraded).

Thus, in this aspect of the present teachings, battery diagnosing devices may comprise one or more devices for respectively measuring one or more degradation indicators of the rechargeable battery, a device for determining the usage quantity of the rechargeable battery, a device for accumulating and storing a plurality of pairs of measured degradation indicator(s) and the determined usage quantities, and a device for estimating, based upon the plurality of pairs of measured degradation indicators and determined usage quantities, a future (remaining) usage quantity of the rechargeable battery.

By accumulating and storing the plurality of pairs of the measured degradation indicator(s) and the corresponding determined usage quantities, it is possible to determine a trend (rate) according to which the degradation indicator changes as the usage quantity increases. It is noted that this trend may vary widely based upon the manner of battery use (e.g., over- or under-discharging the battery before recharging can have significant effects on this trend). Thus, by calculating and utilizing this trend, it is possible to reliably estimate the future (remaining) usage quantity of the battery. Consequently, the operator may be informed as to how much the rechargeable battery may be further used until the degradation thereof is expected to proceed to the prescribed level. Moreover, as in the above embodiments, if the battery condition is degrading abnormally (e.g., excessively fast), the operator can be advised to modify his/her manner of using the batteries in order to utilize a more optimal manner of use and thereby, maximize the remaining operational life of the rechargeable battery.

Naturally, methods based upon this aspect may include: (i) measuring one or more degradation indicator(s) of the rechargeable battery, (ii) determining the usage quantity of the rechargeable battery, (iii) accumulating and storing a plurality of pairs of the measured degradation indicator(s) and the corresponding determined usage quantity, and (iv) estimating the future (remaining) usage quantities based upon the stored plurality of pairs of the measured degradation indicators and the determined usage quantities. The term "future (remaining) usage quantity" has the same meaning noted above.

Furthermore, another technique for estimating the future (remaining) usage quantity of a rechargeable battery provides a battery diagnosing device including: one or more devices for measuring one or more degradation indicator(s) of the rechargeable battery, a device for determining the usage quantity of the rechargeable battery, one or more devices for storing one or more standard (normal) relationships between the degradation indicator(s) and the usage quantity, and a device for estimating the future (remaining) usage quantity of the battery based upon the stored standard relationship(s) between the measured degradation indicator(s) and the corresponding determined usage quantities.

The degradation indicator(s) of the rechargeable battery is (are) selected as objectively measurable values that change as the usage quantity increases. Furthermore, the rate of change of most degradation indicators (with respect to the degree of increase in the usage quantity) is typically not same throughout the period of use of the rechargeable battery, but varies according to the usage quantity. For example, during the period of initial use of a rechargeable battery having a low usage quantity, there is usually little change in the degradation indicators as the usage quantity increases. By contrast, when a rechargeable battery having a high usage quantity is nearing the end of its operational life, relatively large changes are usually observed in the degradation indicator as the usage quantity increases. It is not possible, generally speaking, to know how much the degradation indicator(s) will change as the usage quantity increases by merely detecting the degradation indicator(s). However, it is possible to determine how much the degradation indicator(s) will change as the usage quantity increases by detecting both the degradation indicator and the usage quantity(s).

In the present device, the standard (normal) relationship between the degradation indicator and the usage quantity is stored, which standard relationship may be, e.g., empirically determined based upon optimal methods for using a particular battery. Moreover, the pair of the degradation indicator and the usage quantity is (repeatedly) detected (measured) during usage of the battery. As a result, it is possible to determine, based upon the standard relationship, the expected amount of change of the degradation indicator(s) with respect to the further usage of the battery and thus to reliably predict how long the rechargeable battery can be further used after the most recent detection until the degradation indicator is expected to exceed the reference degradation value (i.e., a value representing the end of the useful operational lift of the battery).

Although the quantity of change of the degradation indicator with respect to the degree of increase in usage quantity is not the same throughout the period of use of the rechargeable battery, it is possible by means of the present device to extrapolate the trend, whereby this change occurs in accordance with the usage quantity. As a result, it is possible to accurately estimate the future remaining usage quantity (i.e., the amount of remaining operational life of the battery).

The technique described above also presents another method for estimating the future usage quantity, which comprises the steps of (i) measuring one or more degradation indicators of the rechargeable battery, (ii) determining the usage quantity of the rechargeable battery, and (iii) estimating, based upon the pair of the measured degradation indicator(s) and the determined usage quantity, and a stored standard (normal) relationship, a future (remaining) usage quantity. Similar to the above described embodiment, the standard relationship between the degradation indicator and the usage quantity optionally may be empirically determined and stored in advance of the execution of this method.

In the diagnosing devices and diagnosing methods described above, it is preferred that the battery's internal resistance and/or the charging/discharging battery capacity is (are) utilized as the degradation indicator(s). Further, one or more of the cumulative discharging time, the cumulative charging time, the cumulative quantity (amount) of discharged power, the cumulative quantity (amount) of charged power, and/or the cumulative number of charging/discharging cycles is preferably utilized as the usage quantity.

Internal resistance is a suitable degradation indicator because the increase in the internal resistance of the rechargeable battery corresponds closely to (changes with a characteristic pattern relative to) the progress of the degradation of the rechargeable battery. Charging/discharging capacity is also a suitable degradation indicator because the decrease in the charging/discharging capacity corresponds closely to (changes with a characteristic pattern relative to) the progress of the degradation of the rechargeable battery.

Furthermore, the degradation of the rechargeable battery progresses in accordance with the cumulative discharging time, the cumulative charging time, the cumulative quantity (amount) of discharged power, the cumulative quantity (amount) of charged power, and the cumulative number of charging/discharging cycles. Consequently, one or more of these quantities can be advantageously chosen as the usage quantity.

In another embodiment, the detected actual usage quantity may be modified based a determination that the battery has been used in a sub-optimal manner. For example, a detected relatively high frequency of occurrence of over-discharging and/or overly-rapid charging may be utilized to determine that the battery has been used in a sub-optimal, and likely damaging, manner. In one preferred embodiment, the detected actual usage quantity may be multiplied by a factor (e.g., 1.5), if it is determined that the manner of using the battery has been less than optimal.

If the rechargeable battery is over discharged or charged too rapidly, the degradation thereof progresses more rapidly than usual. Moreover, if the battery is frequently used in this sub-optimal manner, even if the battery is high quality, the degradation progresses more rapidly than normal. Therefore, in order to diagnose whether a premature degradation of the battery was caused by poor quality battery, an abnormally rapid degradation caused by sub-optimal battery usage should be excluded. In this case, the above-discussed usage quantity is preferably modified (increased) to be larger than the actual measured (determined) usage quantity when sub-optimal battery usage is detected. In other words, when it is determined that the battery has been used in a sub-optimal manner (e.g., repeated over- and/or under-discharging and/or rapid charging of the battery), the measured (detected) actual usage quantity (amount) is increased accordingly, thereby providing a more reliable relationship between the degradation indicator(s) and the usage amount. Thus, by increasing usage quantity value in such situations, it is less likely that premature degradation of the battery will be incorrectly attributed to poor battery quality, rather than improper usage of the battery.

In another aspect of the present teachings, a rechargeable battery may sometimes be fully charged after the battery has been only slightly discharged, which is a well known example of a sub-optimal usage of many types of rechargeable batteries. If such a cycle of slight discharging of the battery followed by full charging is repeatedly performed, the voltage of the rechargeable battery will characteristically fall abruptly when the battery has only been discharged by a relatively small amount. In the art, this phenomenon has been termed a "memory effect" or "memory accumulation," in which the battery "remembers" the point that it stopped discharging, thereby resulting in a reparable drop of the battery's output voltage. As will be further discussed below, this reparable voltage drop can be remedied or corrected, e.g., by performing a "refresh" operation on the battery, in which the battery is fully or deeply discharged before being recharged again.

If the battery has acquired a "memory" and the battery driven equipment has a built-in function to halt operation when the battery voltage falls to a prescribed voltage, the effective charging/discharging capacity of the battery drops. As indicated above, however, such a drop of charging/discharging capacity due to repeated cycles of slight discharging and full charging is not permanent, but rather is temporary or reparable. By fully (or deeply) discharging the battery until the battery voltage becomes very low before recharging the battery again (i.e., a "refresh" operation), the effective charging/discharging battery capacity can be restored to a normal value.

In the following description, if the effective charging/discharging battery capacity has been temporarily (reparably) reduced due to repeated cycles of slight discharging followed by full charging (e.g., the battery has acquired a "memory"), such batteries will be referred to as being in a "non-active" state. The "non-active" state is distinguished from the "degraded" state in the present description, as the "degraded" state is intended to mean that the operational condition of the battery has been irreparably reduced.

Consequently, a technique is required to distinguish whether the rechargeable battery is in the non-active state or active state. If the battery is in the non-active state, it may be possible to recover of the full (normal) charging/discharging capacity of the battery by performing a refresh operation. On the other hand, if the battery is in the active state, any observed drop of the effective charging/discharging capacity is not temporary (reparable), and it is not possible to recover the full or normal effective battery capacity by performing a refresh operation on a "degraded" battery.

Thus, if it is determined that the rechargeable battery is in the non-active state, the full effective charging/discharging capacity can be recovered by performing the refresh operation. But, if it is determined that the rechargeable battery is in the active state while having been degraded abnormally, it is possible to ascertain that the manner of use, or the like, of the rechargeable battery was inappropriate, and improvements to the manner of use should be considered.

A battery diagnosing device for this purpose is also described herein. In other words, such a device preferably determines whether the rechargeable battery is in the active state or the non-active state. The battery diagnosing device of this type preferably comprises: a device for measuring a first degradation indicator representative of the condition of the rechargeable battery, a device for measuring a second degradation indicator representative of the condition of the rechargeable battery, a device for storing a reference activity map, which is preferably a two-dimensional map plotting the first degradation indicator with respect to the second degradation indicator, which map is divided into the active region and the non-active region, and a device for determining whether the pair of the measured first degradation indicator and the measured second degradation indicator falls within the active region or the non-active region of the reference activity map.

Research by the present inventors has determined that, when the measured first degradation indicator is plotted with respect to the second degradation indicator on the two-dimensional map, it is possible to identify a relationship between these values, which relationship can be utilized to reliably predict whether the battery is in the active or the non-active state.

According to this device, the first degradation indicator and the second degradation indicator are detected as a pair, and it is determined whether the pair of measured (detected) values (and thus the rechargeable battery) falls within the active region or the non-active region of the reference map. If the rechargeable battery is in the non-active state, the charging/discharging capacity thereof can be recovered by performing the refresh operation. Furthermore, the device optionally may inform the battery user that sub-optimal usage of the battery has resulted in a premature, but correctable, degradation of the battery capacity, as well as suggest methods for preventing the rechargeable battery from reassuming the non-active state.

According to the technique described above, a method is also provided for determining whether the rechargeable battery is in the active state or the non-active state. This battery diagnosing method preferably comprises the steps of: (i) measuring a first degradation indicator of the rechargeable battery, (ii) measuring a second degradation indicator of the rechargeable battery, and (iii) determining whether the pair of the measured first degradation indicator and measured second degradation indicator fall within an active region or a non-active region of a stored reference map. Similar to the above-described device, the reference activity map may be empirically prepared before the method is performed. In this case, a two-dimensional map may be created by plotting the first degradation indicator with respect to the second degradation indicator and then dividing the map into the active region and the non-active region based upon empirical observations.

In the diagnosing device and diagnosing method described above, it is preferred that the first degradation indicator is the internal resistance of the rechargeable battery, and the second degradation indicator is the charging/discharging capacity of the rechargeable battery.

A rechargeable battery in the non-active state is characterized by the fact that the internal resistance of the battery has only slightly increased, but the effective charging/discharging capacity has been significantly reduced. By contrast, a degrading rechargeable battery in the active state is characterized by the fact that the internal resistance has increased as the charging/discharging capacity has fallen. From this information, by utilizing the two-dimensional map that relates the internal battery resistance to the charging/discharging battery capacity, it is possible to accurately distinguish whether the battery is in the active region or the non-active region.

In another embodiment of the present teachings, the above described methods and devices may be implemented in the form of an adapter that is interposed between a charging device and a rechargeable battery. In this case, the adapter preferably determines whether the rechargeable battery is in the active state or the non-active state and performs a refresh operation (i.e., fully or deeply discharging the battery before recharging it) when it is determined that the battery is in the non-active state. The adapter preferably comprises a supply circuit for supplying a charging current from the charging device to the battery via the adaptor, a circuit for discharging current from the rechargeable battery, a selecting circuit for selecting either the supply circuit or the discharging circuit to function, and a means for switching the selecting circuit, which means enables the discharging circuit to function when a determining device has determined that the pair of degradation indicators is in a non-active region.

The term 'charging device' includes charging devices for charging the rechargeable battery during the normal use of the rechargeable battery.

By interposing such an adapter between the charging device and the rechargeable battery, it is possible to determine whether the rechargeable battery is in the active state or the non-active state. Further, when the rechargeable battery is determined to be in the non-active state (i.e., temporary reduction of effective battery capacity), the rechargeable battery may be forcibly fully discharged and fully charged (refreshed) thereafter by the adapter.

In another aspect of the present teachings, it is noted that rechargeable batteries may be used in a variety of conditions. For example, some users may chose to repeatedly charge the battery rapidly, while some users may only use the rechargeable battery infrequently. Furthermore, some users may perform continuous operations under a light load over a long period, while some users may infrequently perform operations under a heavy load. Moreover, some users may repeatedly over discharge the battery to an extremely low battery voltage.

Although an optimal manner of use may exist for each of these various types of operating conditions in order to maximize the operational lifetime of the battery, it is difficult to identify such an optimal manner. Many issues are unknown and remain to be investigated. Numerous examples must be collected. A large quantity of diagnostic information must be summarized and further knowledge concerning diagnosis must be obtained.

In order to solve this problem, a diagnostic information collecting device is provided that is useful for the above purpose. The diagnostic information collecting device preferably comprises a plurality of terminal diagnosing devices for diagnosing a plurality of rechargeable batteries and obtaining diagnostic information therefrom, an information accumulating device for accumulating and storing the diagnostic information, and a communication means for connecting the terminal diagnosing devices and the information accumulating device via a wireless or wired network.

Each terminal diagnosing device can be one or more of the above-described battery diagnosing devices or adapters. The communication means may be a computer network that transmits (by wire and/or a wireless channel) the diagnostic information obtained by the terminal diagnosing devices to the information accumulating device.

In this diagnostic information collecting device, the diagnostic information concerning the rechargeable batteries obtained by the battery diagnosing devices is transmitted to the information accumulating device via the network, and the diagnostic information concerning the rechargeable batteries is stored in the information accumulating device. Many items of diagnostic information are preferably accumulated in the information accumulating device; therefore, various diagnostic information concerning the various rechargeable batteries that are used in various conditions can be collected. By analyzing the various diagnostic information under the various conditions collected in the information accumulating device, further strategies for diagnosing the rechargeable batteries can be developed.

In a further development of this aspect of the present teachings, it is noted that he reference values of the degradation indicator and the usage quantity, which are needed to determine the state of degradation of the rechargeable battery, can be determined computationally on the basis of the specifications of the rechargeable battery, the estimated manner of use thereof, etc., or can be empirically determined from actual test results, etc. However, it is difficult to have the numerous elements concerning degradation faithfully reflected computationally. In addition, if the reference values are empirically determined on the basis of actual test results, the number of samples that can be obtained is limited, and reliable reference values can not be determined from a limited number of samples. Therefore, a technique for more accurately determining the state of degradation of the rechargeable battery is required.

The above problem may be solved by a reference value calculating means according to the present teachings. The reference value calculating means preferably extracts the relationship between the usage quantity and the degradation indicator from the diagnostic information accumulated by and stored in the information accumulating device of the diagnostic information collecting device. The reference value calculating means also preferably calculates at least one reference value concerning the degradation indicator and the usage quantity. The reference value may be calculated from a normally degrading region, an abnormally degrading region, a standard relationship between the degradation indicator and the usage quantity, an active region, and a non-active region of a large number of the batteries.

The communicating device may then transmit the reference value calculated by the reference value calculating means to the terminal diagnosing devices. Since the terminal diagnosing devices can obtain a more accurate reference value, the terminal diagnosing devices are able to more accurately determine the state of degradation of the rechargeable battery.

In summary, the present teachings provide techniques for:
determining whether a rechargeable battery has degraded normally or abnormally,
estimating the future (remaining) usage quantity, i.e., how much the rechargeable battery may be further used until it degrades to the prescribed level,
determining whether the rechargeable battery is in the active state or the non-active state and
obtaining information useful to diagnose a variety of rechargeable batteries and collecting such information in an information collecting device.

However, it should be noted that additional techniques, aspects, objects and advantages of the present teachings will become apparent to the skilled person upon reading the following detailed description of the present invention with reference to the appended drawings, in which:
FIG. 1 shows the external appearance of a battery checking/charging system.
FIG. 2 shows the external appearance of a battery pack.
FIG. 3 shows the external appearance of a charger.
FIG. 4 shows the external appearance of a checking adapter.
FIG. 5 shows the electrical configuration when the battery pack is attached to the charger.
FIG. 6 shows the electrical configuration of the battery pack, the checking adapter, and the charger.
FIG. 7 shows an example of a reference degradation map relating to internal resistance.
FIG. 8 shows an example of a reference activity map.
FIG. 9 is a flowchart showing a representative sequence of operation of the battery checking system.
FIG. 10 shows a process for estimating, from the change of internal resistance, the degree of progress of degradation.
FIG. 11 shows an example of a reference degradation map relating to charging/discharging capacity.
FIG. 12 shows an example of diagnostic results appearing on a display.
FIG. 13 shows an example of diagnostic results (of a product in initial stages of use) appearing on the display.
FIG. 14 shows an example of diagnostic results (of a non-active state) appearing on the display.
FIG. 15 shows an example of diagnostic results (of a product wherein degradation is completed) appearing on the display.
FIG. 16 shows an example of diagnostic results (of a defect product) appearing on the display.
FIG. 17 shows the configuration of a battery checking network.
FIG. 18 shows the configuration of a battery diagnostic device of third embodiment.
FIG. 19 shows a display of the battery diagnostic device of the third embodiment.
FIG. 20 is a flowchart showing a representative sequence of operation of the battery diagnostic device of the third embodiment.
FIG. 21 shows a diagnostic reference utilized in a combined diagnosis of the battery diagnostic device of the third embodiment.
FIG. 22 shows a process whereby the battery diagnostic device of the third embodiment estimates a number of remaining charging/discharging cycles from a plurality of pairs of data.

Preferred features of the present teachings include:
(1) A battery checking system comprising a charger, a checking adaptor attachable to the charger, and a computer device connectable with the checking adaptor.
(2) A battery checking system adapted to diagnose the state of degradation (condition) of rechargeable batteries within a battery pack attached to the checking adaptor.
(3) A battery pack having a storage device (for example, an EEPROM) that stores charging number data, a history of remaining quantity of power data, temperature history data, charging characteristics data, battery pack data, etc.
(4) A charger that, when the battery pack is used normally, charges the battery pack.
(5) A checking adaptor having a switch for selecting either a connecting circuit or a discharging circuit to operate on the battery pack. The connecting circuit electrically connects the charger to the rechargeable battery of the battery pack for recharging, and the discharging circuit causes the rechargeable battery to be discharged.
(6) A computer device storing a two-dimensional reference degradation map (LUT) with respect to internal resistance, plotting internal resistance with respect to the cumulative number of chargings (i.e., these values serve as indices for the LUT), which map is divided into a "normally degrading" region, an "abnormally degrading" region, a "normally degraded" region, and an "abnormally degraded" region. Optionally, the computer device also stores a reference activity map, which is a two-dimensional map plotting internal resistance with respect to charging/discharging capacity and divided into an "active" region and a "non-active" region.
(7) A computer device provided with a display for indicating diagnosis results, etc. of the battery pack.
(8) A battery checking system capable of reading information from a storage device enclosed within the battery pack, and writing information to said storage device. The battery checking system, e.g., writes the diagnosis results to said storage device.
(9) A battery checking system capable, by means of a charging circuit within the charger and the discharging circuit within the checking adaptor, of fully charging and fully discharging the battery pack.
(10) A battery checking system storing diagnostic information concerning the battery pack relating to previous diagnoses thereof. The diagnostic information is stored together with identifying information for the battery pack.
(11) A battery checking system connectable via a wireless or wired network (e.g., the internet) to a host computer. The diagnostic information can be transmitted via the network, and the reference degradation map relating to internal resistance, the reference activity map, etc. also can be sent via the network.

Each of the additional features and teachings disclosed below may be utilized separately or in conjunction with other features and teachings to provide improved methods and apparatus for diagnosing the condition of rechargeable batteries and methods for designing and using the same. Representative examples of the present invention, which examples utilize many of these additional features and teachings both separately and in combination, will now be described in further detail with reference to the attached drawings. This detailed description is merely intended to teach a person of skill in the art further details for practicing preferred aspects of the present teachings and is not intended to limit the scope of the invention. Therefore, combinations of features and steps disclosed in the following detail description may not be necessary to practice the invention in the broadest sense, and are instead taught merely to particularly describe representative examples of the present teachings.

Moreover, the various features of the representative examples and the dependent claims may be combined in ways that are not specifically and explicitly enumerated in order to provide additional useful embodiments of the present teachings. In addition, it is expressly noted that all features disclosed in the description and/or the claims are intended to be disclosed separately and independently from each other for the purpose of original disclosure, as well as for the purpose of restricting the claimed subject matter independent of the compositions of the features in the embodiments and/or the claims. It is also expressly noted that all value ranges or indications of groups of entities disclose every possible intermediate value or intermediate entity for the purpose of original disclosure, as well as for the purpose of restricting the claimed subject matter.

### EMBODIMENT 1

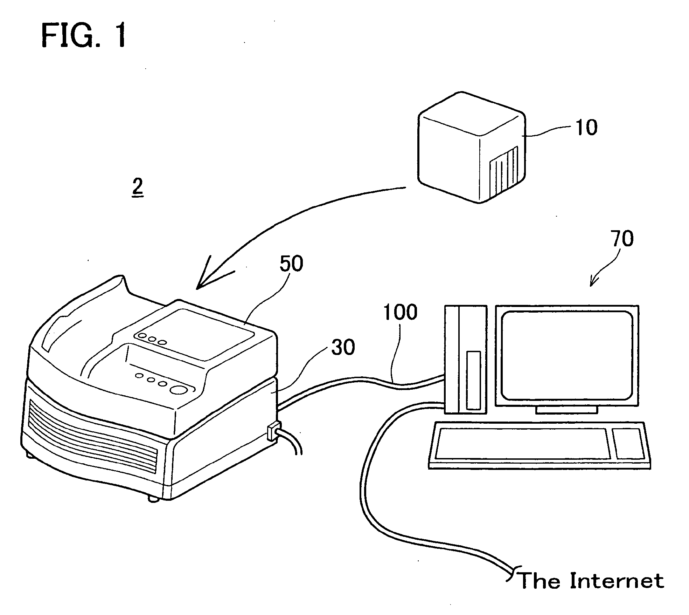

FIG. 1 shows the external appearance of a representative battery checking system 2, which comprises a charger 30 for charging a battery pack 10, a checking adaptor 50, and a computer device 70, etc.

FIG. 1 shows the checking adaptor 50 attached to the charger 30, and the checking adaptor 50 and the computer device 70 connected by a cable 100. In this state, the battery pack 10 is attached to the checking adaptor 50, the state of degradation of the battery pack 10 is diagnosed, and the diagnosis results are shown on the computer 70.

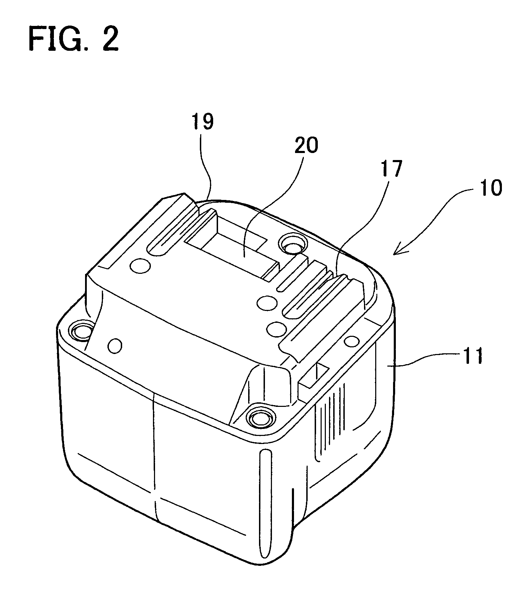

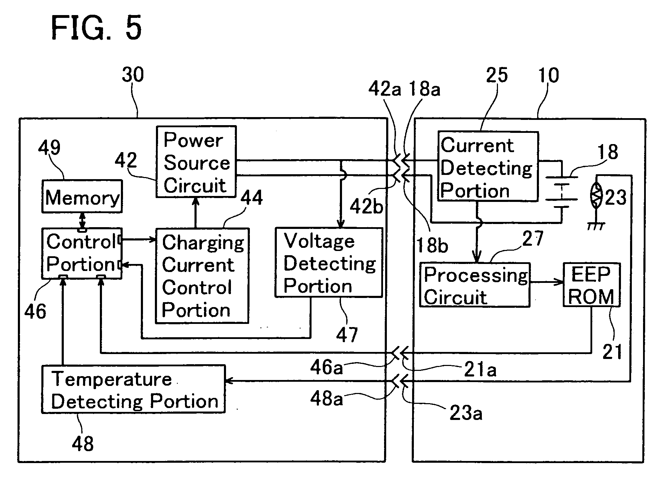

First, the battery pack 10 will be described using FIG. 2 and FIG. 5. The battery pack 10 may be used with a power tool (for example, an impact driver). When the battery pack 10 is attached to the power tool, the battery pack 10 supplies power to a driving source (for example, a motor) of the power tool.

As shown in FIG. 2, the battery pack 10 has a substantially square-pillar shaped casing 11 made of resin. An upper side of the casing 11 is shaped such that it can be fitted, when attached thereto, with a corresponding power tool, the charger 30, or the checking adaptor 50.

The upper side of the casing 11 has a plus terminal groove 17, a minus terminal groove 19, and a connector 20. A plus terminal 18a (shown in FIG. 5) is provided within the plus terminal groove 17 and a minus terminal 18b (shown in FIG. 5) is provided within the minus terminal groove 19. A memory terminal 21a and a temperature sensor terminal 23a (both shown in FIG. 5) are provided within the connector 20. The terminals are formed so as to contact the corresponding receiving terminals and output terminals when the battery pack 10 is attached to the power tool, the charger 30, or the adaptor 50.

As shown in FIG. 5, a plurality of rechargeable batteries 18, an EEPROM 21, a temperature sensor 23, a current detecting portion 25, and a processing circuit 27 are housed within the casing 11 of the battery pack 10.

A plurality of rechargeable batteries 18 (e.g., ten nickel metal hydride batteries) are preferably connected in series.

The positive pole side of the rechargeable batteries 18 is connected with the plus terminal 18a via the current detecting portion 25. The negative pole side of the rechargeable batteries 18 is connected with the minus terminal 18b. In this particular embodiment, the voltage across the plus terminal 18a and the minus terminal 18b is approximately 12V when the battery 18 is fully charged. Naturally, other voltages may be generated by changing the number, type and/or configuration of the batteries 18.

The current detecting portion 25 detects the value of the charging current or the value of the discharging current of the rechargeable batteries 18, and sends this information to the processing circuit 27. The processing circuit 27 calculates, over time, the remaining capacity of the rechargeable batteries 18 on the basis of the charging and discharging current values of the rechargeable batteries 18 that were sent, and sends this information to the EEPROM 21.

The temperature sensor 23 is provided in the vicinity of the rechargeable batteries 18 and detects the temperature thereof. The temperature sensor 23 preferably includes a thermistor having a current resistance that varies in response to temperature changes. The temperature sensor 23 is connected with the temperature sensor terminal 23a.

The EEPROM 21, which stores electronic information, is provided within the casing 11. The EEPROM 21 is connected with the memory terminal 21a.

Data concerning the number of chargings (hereafter referred to as "charging number data"), the history of remaining quantity of power data, the temperature history data, charging characteristics data, battery pack data, previous diagnostic data, etc. is stored in the EEPROM 21.

The total (cumulative) number of chargings, the number of full chargings, etc. is stored in the charging number data. The total number of chargings is the cumulative number of charging operations performed (initiated) thus far on the battery pack 10. The number of full chargings is the cumulative number of charging operations performed on the battery pack 10 whereby a fully charged state was reached. Thus, the difference between the total number of chargings and the number of full chargings is the number of times in which charging of the battery pack 10 was halted before a fully charged state was reached.

The history of the remaining quantity of charged power of the rechargeable batteries 18 is stored in the history of remaining quantity data, which includes data concerning the remaining battery capacity of the batteries 18 when each recharge operation was performed. As will be further discussed below, this historical data is useful to determine whether the batteries 18 were regularly over- and/or under-discharged before being re-charged.

The remaining quantity of charged power of the rechargeable batteries 18 is calculated by the processing circuit 27 and the processed data is sent to the EEPROM 21. The current detecting portion 25 detects current values of the rechargeable batteries 18 during discharging and charging. On the basis of the charging and discharging current values detected by the current detecting portion 25, the processing circuit 27 adjusts the remaining quantity stored in the history of remaining quantity data while it stores the history of the remaining quantity. When the battery pack 10 is completely discharged by means of a refresh operation or the like, the remaining quantity values stored in the history of remaining quantity data may be reset to zero. By this means, accumulated errors can be removed.

The history of the temperature of the rechargeable batteries 18 during charging is stored in the temperature history data. The charger 30 updates the temperature history data when the charger 30 charges the battery pack 10. Rechargeable batteries 18 typically become greatly heated when they are charged rapidly. Therefore, if the temperature of the rechargeable batteries 18 is relatively or unusually high during charging, it can be reasonably deduced that the rechargeable batteries 18 are being charged rapidly. All temperature values of the rechargeable batteries 18 during charging may be stored in the temperature history data, or only the highest temperature values, lowest temperature values, etc. during charging may be extracted and stored. In the present embodiment, all temperature values of the rechargeable batteries 18 during charging are stored.

Characteristics relating to the charging of the battery pack 10 are stored in the charging characteristics data. For example, one or more charging currents suitable for the rechargeable batteries 18 of the battery pack 10, the frequency of the refresh operation suitable for the rechargeable batteries 18, etc. are stored.

The properties of the battery pack 10 also may be stored in the battery pack data. The properties of the battery pack 10 include, for example, the classification (type of cell), the nominal voltage, and the nominal charging/ discharging capacity, etc. of the rechargeable batteries 18 within the battery pack 10. Further, identification data (e.g., individual ID codes), etc. for distinguishing the battery pack 10 from other battery packs, may be stored.

Information relating to previous diagnoses of the battery pack 10 performed by the battery checking system 2 is stored in the previous diagnostic data. For example, one or more of the time of the previous diagnoses, the internal resistance values, the charging/ discharging capacity, the number of chargings of the rechargeable batteries 18 at the time of the previous diagnoses, and the diagnosis results, etc. of the battery checking system 2 at the time of the previous diagnoses may be stored in the previous diagnostic data.

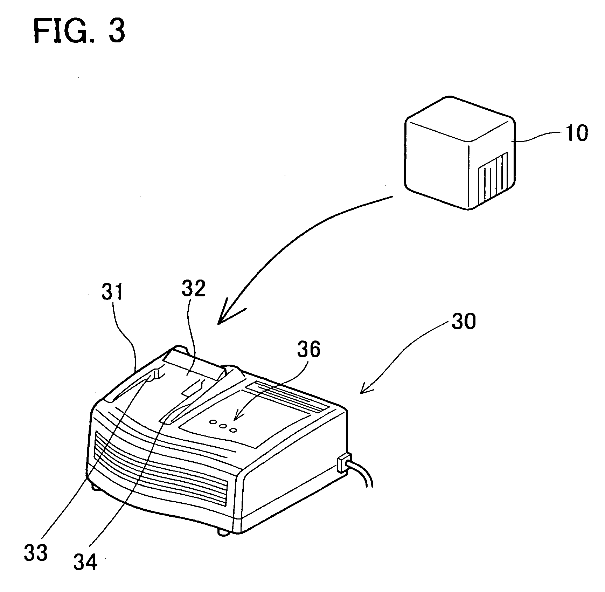

Next, the charger 30 will be described using FIG. 3 and FIG. 5. As shown in FIG. 1, the adapter 50 can be attached to the charger 30 and, as shown in FIG. 3, the battery pack 10 can be attached directly to the charger 30. The charger 30 is used not only in the battery checking system 2, but is also used as a charger for charging the battery pack 10 during the normal use thereof.

As shown in FIG. 3, the charger 30 has a housing 31 made of resin. A connecting portion 32 is integrally formed in an upper face of the housing 31, which connecting portion 32 is shaped such that it can be attached to the battery pack 10 and to the adapter 50. Further, a variety of indicators 36 are provided on the housing 31, such as a status indicating lamp for indicating the operating status of the charger 30, etc.

Guides 33 and 34 for (slidably) guiding the battery pack 10 and the adapter 50 are also provided in the connecting portion 32. A plus output terminal 42a and a minus output terminal 42b (shown in FIG. 5) are provided between the guides 33 and 34 of the connecting portion 32. Further, a connector (not shown) capable of making contact with the connector 20 of the battery pack 10 is provided, and terminals 46a and 48a shown in FIG. 5 are located in the vicinity of this connector.

As shown in FIG. 5, a control circuit of the charger 30 is principally composed of a power source circuit 42, a charging-current controlling portion 44, a control portion (controller) 46, a voltage detecting portion 47, a temperature detecting portion 48, and a memory 49, etc.

The power source circuit 42 supplies current for charging the rechargeable batteries 18 of the battery pack 10. The temperature detecting portion 48 is capable of detecting, based upon the output of the temperature sensor 23 of the battery pack 10, the temperature of the rechargeable batteries 18. The voltage detecting portion 47 is capable of detecting the voltage of the rechargeable batteries 18. Memory 49 stores charging current value controlling information based on a prescribed map or the like.

The above power source circuit 42, charging-current controlling portion 44, control portion 46, voltage detecting portion 47, temperature detecting portion 48, storage portion 49, etc. may be constructed according to EP 1 039 612 or EP 1 039 613 so as to select the battery charging currents. Memory 49 stores one or more maps (LUTs) for selecting the charging current values based upon the detected temperature of the rechargeable batteries and values relating to the rate of battery temperature change (increase). For example, a plurality of charging current maps may be stored in memory 49, and each map is prepared on the basis of the particular characteristics etc. of the rechargeable batteries to be charged.

As shown in FIG. 5, when the battery pack 10 is attached to the connecting portion 32 of the charger 30, the terminals 18a, 18b, 21a, and 23a provided on the battery pack 10 make electrical contact with, respectively, the terminals 42a, 42b, 46a, and 48a provided on the charger 30.

The control portion 46 reads the charging characteristics data from the EEPROM 21 of the battery pack 10, and utilizes a prescribed algorithm to control the power source circuit 42, the charging-current controlling portion 44, the voltage detecting portion 47, and the temperature detecting portion 48, etc. As a result, the rechargeable batteries 18 within the battery pack 10 are charged.

When charging begins, the control portion 46 sends a message to increment by one (1) the cumulative number of chargings, which is stored in the charging number data in the EEPROM 21.

During charging, the control portion 46 determines the temperature of the rechargeable batteries 18 and sends this temperature information to the temperature history data stored in the EEPROM 21.

Upon completion of a full charge, the termination of the charging operation may be indicated by a lamp or other visible and/or audible means. The control portion 46 sends a message to increment by one (1) the number of full chargings, which is also stored in the charging number data in the EEPROM 21.

Additionally, as will be described below, the charger 30 is configured so as to be capable of performing various other functions, such as charging etc., when the checking adapter 50 has been attached to the charger 30, which charger 30 is controlled by the checking adapter 50.

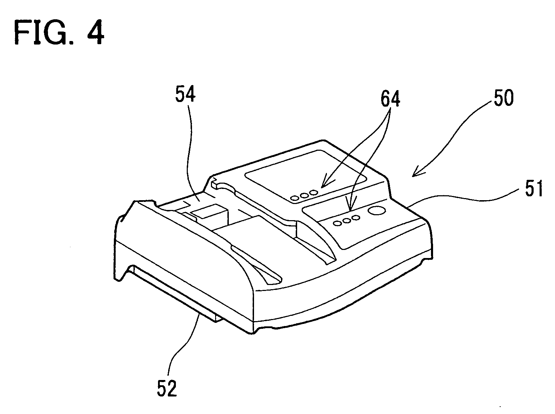

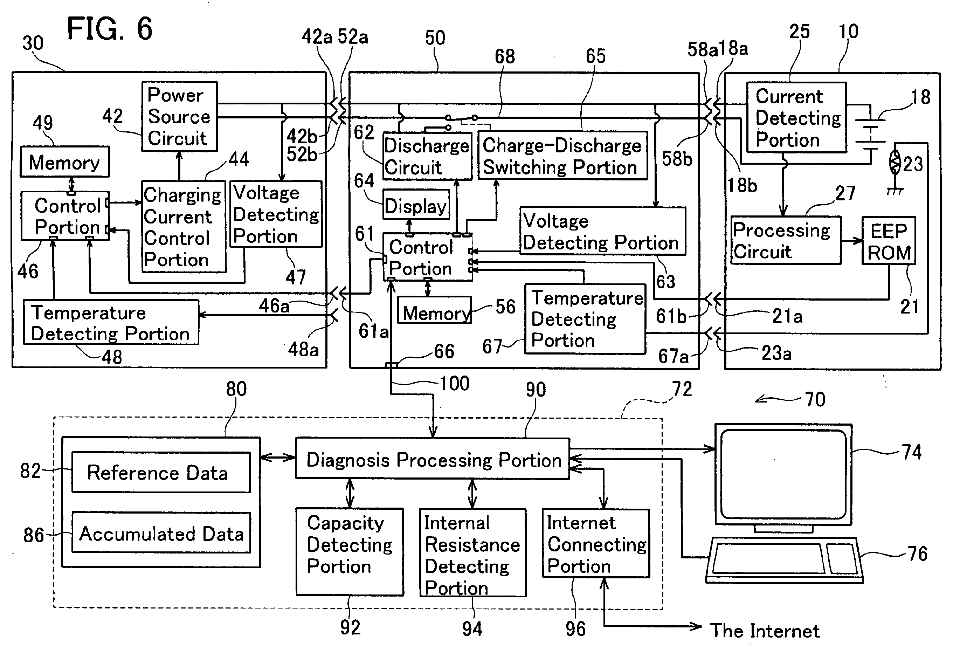

Next, a preferred configuration of the checking adaptor 50 will be described with the aid of FIGS. 4 and 6. As shown in FIG. 4, the checking adapter 50 has a casing 51 made of resin. A lower face of the casing 51 has a connecting portion 52 formed thereon, which connecting portion 52 is designed to fit with the connecting portion 32 of the charger 30. An upper face of the casing 51 also has a connecting portion 54 formed thereon, which connecting portion 54 is designed to fit with the battery pack 10.

Further, a display 64 composed of a variety of lamps is provided on the upper face of the casing 51. The operating status of the charger 30, the operating status of the checking adapter 50, etc. are indicated on the display 64.

The connecting portion 52 on the lower face of the casing 51 is provided with a plus receiving terminal 52a and a minus receiving terminal 52b (both shown in FIG. 6). Further, a connector (not shown) for connecting with a connector 20 of the charger 30 is provided, and a terminal 61a (shown in FIG. 6) is located in the vicinity of this connector.

The connecting portion 54 on the upper face of the casing 51 is provided with a plus output terminal 58a and a minus output terminal 58b (both shown in FIG. 6). Further, a connector (not shown) for connecting with the connector 20 of the battery pack is provided, and terminals 6 1 b and 67a (both shown in FIG. 6) are located in the vicinity of this connector.

A communication terminal 66 (shown in FIG. 6) is provided on a rear face of the casing 51. As shown in FIG. 6, the communication cable 100 is connected with the communication terminal 66. The checking adapter 50 and the computer 70 are connected by means of this communication cable 100.

As shown in FIG. 6, a control circuit of the checking adapter 50 is principally composed of a control portion 61, a discharge circuit 62, a voltage detecting portion 63, the display 64, a temperature detecting portion 67, a relay 68, and a charge-discharge switching portion 65 for controlling the relay 68, etc. The control circuit operates from power supplied by the charger 30.

The discharge circuit 62 comprises a resistance or the like that functions as a load in order to discharge the rechargeable batteries 18 during a refresh operation. The discharging current can be adjusted, on the basis of commands from the control portion 61, by adjusting the load resistance values of the discharge circuit 62.

The voltage detecting portion 63 is configured so as to be capable of detecting the voltage of the rechargeable batteries 18 and sending this information to the control portion 61.

The charge-discharge switching portion 65 switches the relay 68 on the basis of commands from the control portion 61. By this means, the rechargeable batteries 18 of the battery pack 10 are connected with the power source circuit 42 of the charger 30 or with the discharge circuit 62 of the checking adapter 50.

The temperature detecting portion 67 is capable of detecting, based upon the output of the temperature sensor 23 of the battery pack 10, the temperature of the rechargeable batteries 18. The temperature detecting portion 67 detects the temperature of the rechargeable batteries 18 and sends this information to the control portion 61.

The control portion 61 of the checking adapter 50 has a communicating function, and communicates information with the control portion 46 of the charger 30 and with the computer 70. Further, the control portion 61 is capable of reading information from the EEPROM 21 of the battery pack 10 and writing information to the EEPROM 21.

As shown in FIG. 6, when the checking adapter 50 is attached to the charger 30, the terminals 52a, 52b, and 61a provided on the checking adapter 50 electrically contact, respectively, the terminals 42a, 42b, and 46a provided on the charger 30. Further, when the checking adapter 50 is attached to the battery pack 10, the terminals 58a, 58b, 61b, and 67a provided on the checking adapter 50 electrically contact, respectively, the terminals 18a, 18b, 21a, and 23a provided on the battery pack 10.

When the charger 30, the checking adapter 50, and the battery pack 10 are connected in series, the control portion 61 of the checking adaptor 50 is capable of reading information stored in the EEPROM 21. Further, the control portion 61 is capable of giving commands to the control portion 46 of the charger 30, the discharge circuit 62, or the charge-discharge switching portion 65, etc., thereby charging or discharging the rechargeable batteries 18. For example, the control portion 61 is capable of fully charging the rechargeable batteries 18 after having fully discharged them, thereby performing a refresh operation on the rechargeable batteries 18.

Next, the configuration of the computer device 70 will be described utilizing FIG. 6. The computer device 70 is composed of a computer main body 72, a display 74, an input device 76, etc.

As shown in FIG. 6, the computer main body 72 is composed of a storage portion 80 for storing data, etc. utilized in various types of processes, a diagnosis processing portion 90 for performing processes (executing programs) relating to the diagnosis of the battery pack 10, a capacity detecting portion 92 for detecting the charging/ discharging capacity of the rechargeable batteries 18, an internal resistance detecting portion 94 for calculating the internal resistance of the rechargeable batteries 18, and an internet connecting portion 96, etc. The storage portion 80, the diagnosis processing portion 90, the capacity detecting portion 92, the internal resistance detecting portion 94, the internet connecting portion 96, etc. comprise the hardware, software, etc. of the computer main body 72.

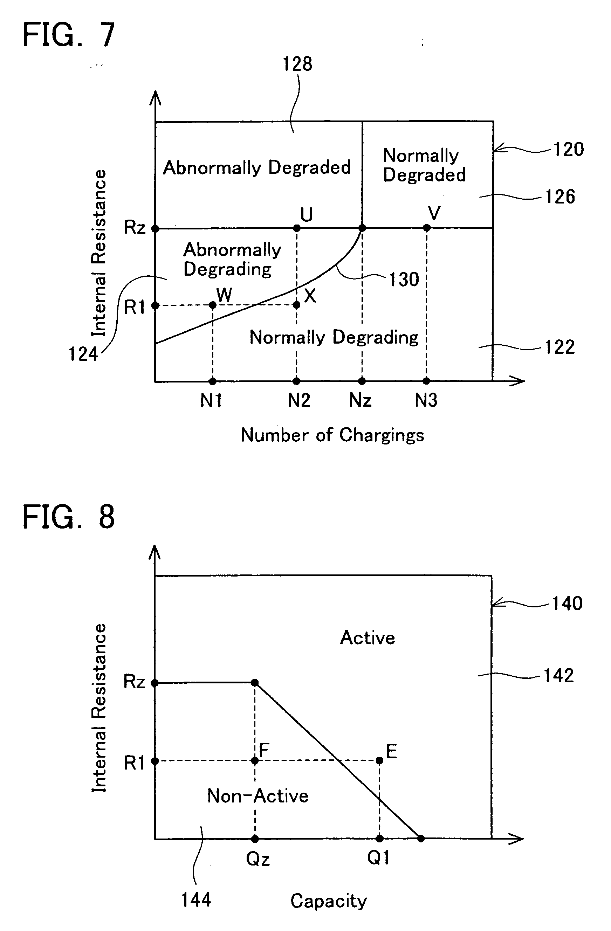

Reference data 82 is stored in the storage portion 80. A reference degradation map 120 relating to internal resistance (shown in FIG. 7) and a reference activity map 140 (shown in FIG. 8), etc. are stored in the reference data 82.

As shown in FIG. 7, the reference degradation map 120 relating to internal resistance is a two-dimensional map wherein the number of chargings is indicated on the horizontal axis and internal resistance is indicated on the vertical axis. The reference degradation map 120 has a "normally degrading" region 122, an "abnormally degrading" region 124, a "normally degraded" region 126, and an "abnormally degraded" region 128, which are determined on the basis of the relationship between the number of chargings and the battery internal resistance. A curved line 130 separates the normally degrading region 122 from the abnormally degrading region 124 and indicates the standard (normal) relationship between number of chargings and the internal resistance of the rechargeable batteries 18 for the case where the manufacture and use of the battery pack 10 is normal. The internal resistance value Rz shown in Figure 7 is a degradation reference resistance value Rz. The rechargeable batteries 18 can be determined to have degraded to a limit stage, at which the batteries can no longer be utilized, when the internal resistance thereof increases so as to be greater than this internal resistance value Rz. Further, the number of chargings Nz is a reference number of chargings Nz. When the rechargeable batteries 18 have been utilized normally, the internal resistance thereof is predetermined not to be greater than the degradation reference resistance value Rz at this reference number of chargings Nz.

In the "normally degrading" region 122, the internal resistance relative to the number of chargings is equal to or below the standard value, which indicates that the rechargeable batteries 18 are degrading normally relative to the number of chargings. In the "abnormally degrading" region 124, the internal resistance relative to the number of chargings is above the standard value, which indicates that the rechargeable batteries 18 are degrading abnormally (faster than normal) relative to the number of chargings. In the "normally degraded" region 126, the number of chargings is equal to or above the reference number of chargings Nz and internal resistance is equal to or above the degradation reference resistance value Rz, which indicates that the rechargeable batteries 18 have degraded normally to the stage at which they can no longer be utilized. In the "abnormally degraded" region 128, the number of chargings is less than the reference number of chargings Nz and the internal resistance is equal to or above the degradation reference resistance value Rz, which indicates that the rechargeable batteries 18 have degraded abnormally (faster than normal) to the stage at which they can no longer be utilized.

As shown in FIG. 8, the reference activity map 140 is a two-dimensional map wherein the charging/ discharging capacity is indicated on the horizontal axis and internal resistance is indicated on the vertical axis. The reference activity map 140 has an "active" region 142 and a "non-active" region 144, which are determined on the basis of the relationship between the charging/ discharging capacity and the internal resistance of the rechargeable batteries 18. In the "non-active" region 144, the charging/ discharging capacity of the batteries 18 is relatively small, but the internal resistance is still relatively low. As will be discussed further below, a "non-active" battery preferably should be subjected to a "refresh" operation in order to restore its full charging/discharging capacity.

For rechargeable batteries 18 in which degradation has not progressed (i.e., relatively new batteries), the charging/ discharging capacity has barely decreased and the internal resistance has barely increased. However, for rechargeable batteries in which degradation has progressed (e.g., batteries that have been subjected to many discharge/charge cycles), the charging/ discharging capacity falls significantly, and the internal resistance increases significantly. By contrast, when the rechargeable batteries 18 are in the "non-active" state, the charging/ discharging capacity has fallen significantly, while the internal resistance has barely increased. Consequently, it is possible to determine that rechargeable batteries are in the "non-active" state when the charging/ discharging capacity has significantly decreased, but the internal resistance has barely increased.

Based upon these relationships, the two-dimensional map of FIG. 8 was devised, wherein the charging/ discharging capacity is indicated on the horizontal axis and internal resistance is indicated on the vertical axis. In this map, the region in which the charging/discharging capacity is low and internal resistance is low is identified as the "non-active" region. The charging/ discharging capacity value Qz shown in Figure 8 is a degradation reference capacity value Qz. It can be determined that the rechargeable batteries 18 have degraded when their charging/ discharging capacity is less than the charging/ discharging capacity value Qz. As in the above description concerning FIG. 7, when the rechargeable batteries 18 have degraded, their internal resistance increases to be greater than the degradation reference resistance value Rz. That is, it has been predetermined that the internal resistance of the rechargeable batteries 18 will have increased to the degradation reference resistance value Rz when the charging/ discharging capacity of the rechargeable batteries 18 has decreased to the degradation reference capacity value Qz. Further, it has been predetermined that the (normal) number of chargings at this time will be the reference number of chargings Nz.

As shown in FIG. 6, accumulated diagnostic information data 86 is also stored in the storage portion 80 of the computer 70. Diagnostic information concerning the battery pack 10 that has been diagnosed to date by the battery checking system 2 is accumulated and stored in the accumulated diagnostic information data 86. For example, the data read from the EEPROM 21 of the battery pack 10, the data calculated at the time of diagnosis, data input by the user, etc. are stored in the accumulated diagnostic information data 86.

The capacity detecting portion 92 is capable of detecting the charging/ discharging capacity of the rechargeable batteries 18. For example, the capacity detecting portion 92 preferably extracts the most recent maximum value from the history of remaining quantity data stored in the EEPROM 21 of the battery pack 10, thereby detecting the charging/discharging capacity of the rechargeable batteries 18.

The internal resistance detecting portion 94 is capable of calculating internal resistance values of the rechargeable batteries 18, which are calculated from the voltage values of the rechargeable batteries 18 during charging or discharging. For example, the internal resistance detecting portion 94 is preferably capable of calculating the internal resistance from the voltage values of the rechargeable batteries 18 during a non-conducting state, and the voltage values when the rechargeable batteries 18 are being discharged using a prescribed current.

The internet connecting portion 96 is capable of connecting the computer 70 with the internet. When connected with the internet by means of the internet connecting portion 96, the computer device 70 is capable of exchanging electronic information with external computer devices, etc.

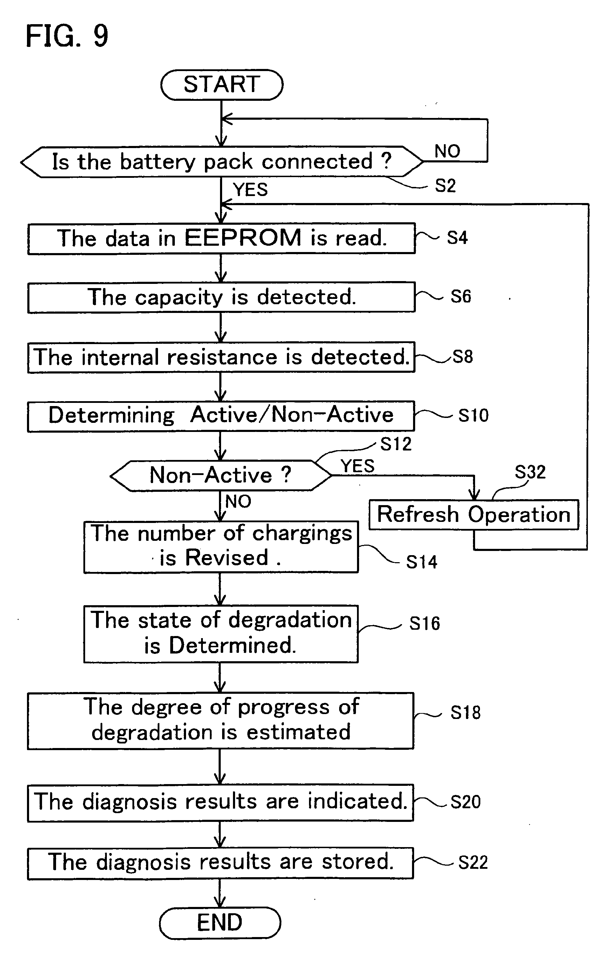

The configuration of the battery checking system 2 of the present embodiment was described above. Next, a representative sequence of operation of the battery checking system 2 will be described with reference to the flowchart shown in FIG. 9.

At step S2, the battery pack 10 is in a waiting state prior to being attached to the checking adaptor 50. The fact that the battery pack 10 has been attached can be recognized by, for example, the voltage detecting portion 63 detecting the voltage of the rechargeable batteries 18.

At step S4, the control portion 61 of the checking adapter 50 reads information from the EEPROM 21 of the battery pack 10. The control portion 61 sends the information read from the EEPROM 21 to the diagnosis processing portion 90 of the computer device 70. The control portion 61 of the checking adapter 50 and the diagnosis processing portion 90 of the computer device 70 detect, for example, the number of chargings, etc. of the rechargeable batteries 18 from the charging number data, the history of remaining quantity data, the temperature history data, the charging characteristics data, and/or the battery pack data of the battery pack 10.

At step S6, the charging/ discharging capacity of the rechargeable batteries 18 is detected. The history of remaining quantity data of the battery pack 10 is sent from the diagnosis processing portion 90 to the capacity detecting portion 92, the capacity detecting portion 92 extracts the most recent maximum value from the history of remaining quantity data and thereby detects the charging/ discharging capacity of the rechargeable batteries 18. However, the method for detecting the charging/ discharging capacity of the rechargeable batteries is not limited to the method described above. Instead, other methods may also be utilized. For example, the rechargeable batteries 18 may be fully charged after being fully discharged, and the quantity (amount) of power required to recharge the batteries 18 may be measured at that time.

At step S8, the internal resistance of the rechargeable batteries 18 is detected. The diagnosis processing portion 90 is controlled by the control portion 61 of the checking adaptor 50 and performs diagnostic charging and discharging of the rechargeable batteries 18. During this diagnostic charging and discharging, the voltage values of the rechargeable batteries 18 are detected by the voltage detecting portion 63 of the checking adapter 50, and are sent to the internal resistance detecting portion 94 via the control portion 61 and the diagnosis processing portion 90. The internal resistance detecting portion 94 calculates the internal resistance of the rechargeable batteries 18 from the voltage values of the rechargeable batteries 18 relative to the diagnostic charging and discharging.

The number of chargings, the charging/ discharging capacity, the internal resistance, etc. of the rechargeable batteries 18 is detected by means of steps S4, S6, and S8 described above.

At step S 10, shown in FIG. 9, a determining process is performed to determine whether the rechargeable batteries 18 are in the active state or the non-active state, as was explained above. The diagnosis processing portion 90 looks up, on the reference activity map (LUT) 140 (FIG. 8), the value of the charging/ discharging capacity detected at step S6 relative to internal resistance measured at step S8, and determines whether the rechargeable batteries 18 are in the active state or the non-active state.

For example, when the detected charging/ discharging capacity is Q1 and the detected internal resistance is R1 as shown in FIG. 8, it is determined that the rechargeable batteries 18 are in the active state. However, when for example the detected charging/ discharging capacity is the degradation reference capacity value Qz, and the detected internal resistance is the internal resistance value R1, it is determined that the rechargeable batteries 18 are in the non-active state. If determinations were made only based upon the charging/ discharging capacity, it would be determined that the rechargeable batteries 18 have irreparably degraded when the charging/ discharging capacity has become the degradation reference capacity value Qz. By contrast, in the battery checking system 2, determination is made by utilizing both the charging/ discharging capacity and the internal resistance, and consequently it is possible to determine that the rechargeable batteries 18 are in the non-active state in this case.

At step S12, the process proceeds to step S 14 if it was determined at step S10 that the rechargeable batteries 18 are in the active state, and the process proceeds to step S32 if it was determined at step S10 that the rechargeable batteries 18 are in the non-active state.

If the process proceeds to step S32, a refresh operation of the rechargeable batteries 18 is performed. When the diagnosis processing portion 90 determines that the rechargeable batteries 18 are in the non-active state, the diagnosis processing portion 90 commands the control portion 61 of the checking adapter 50 to perform a refresh operation on the rechargeable batteries 18. When this command is received, the control portion 61 of the checking adapter 50 sends commands to the control portion 46 of the charger 30, the discharge circuit 62, the charge-discharge switching portion 65, etc., and a refresh operation of the rechargeable batteries 18 is performed. After the refresh operation has been performed, the process returns to step S4. The history of remaining quantity data after the refresh operation is read from the EEPROM 21 of the battery pack 10 at step S4, and the charging/discharging capacity of the rechargeable batteries 18 after the refresh operation is detected at step S6. In this manner, the battery checking system 2 performs a refresh operation for the "non-active" rechargeable batteries 18 in order to restore the full charging/ discharging capacity that had been temporarily reduced and then the diagnosing process of the rechargeable batteries 18 is continued.

At step S 14 of FIG. 9, the number of chargings of the battery pack 10 detected in step S4 is revised on the basis of the history of use of the battery pack 10. In the present embodiment, the history of use of the battery pack 10 is estimated from the history of remaining quantity data and the history of temperature data read at step S4. The diagnosis processing portion 90 counts, from the history of remaining quantity data, the number of times that the remaining quantity of the rechargeable batteries 18 has fallen below a predetermined lower limit value. The counted number of times is the number of times that the rechargeable batteries 18 have been over discharged. Furthermore, the diagnosis processing portion 90 counts, from the temperature history data, the number of times that the temperature of the rechargeable batteries 18 has risen above a predetermined upper limit value. The counted number of times is the number of times that the rechargeable batteries 18 have been charged too rapidly. The diagnosis processing portion 90 calculates, from the number of times of over discharge and the number of times of over-rapid charging of the rechargeable batteries 18, the frequency of occurrence of over discharge and over-rapid charging, and upwardly revises the detected actual number of chargings in accordance with this frequency of occurrence. By increasing the number of chargings in this manner, the rechargeable batteries 18 that have been repeatedly used in a manner that fosters their degradation are evaluated as having been charged a greater number of times than the actual number of chargings.

At step S16, a determining process is performed to determine the state of degradation of the rechargeable batteries 18. Specifically, it is determined whether the rechargeable batteries 18 have degraded to the stage at which they can no longer be utilized. When the rechargeable batteries 18 have degraded to this stage, it is determined whether the rechargeable batteries 18 have degraded normally or abnormally. If the rechargeable batteries 18 are still in a state in which they can be further utilized, it is determined whether the rechargeable batteries 18 are degrading normally or abnormally.

The diagnosis processing portion 90 looks up, on the reference degradation map (LUT) 120 (FIG. 7), the number of chargings of the rechargeable batteries 18 that was revised at step S 14 and the values relative to the internal resistance of the rechargeable batteries 18 that were detected at step S8, and determines the state of degradation of the rechargeable batteries 18. As shown in FIG. 7, when for example a point such as U in the abnormally degraded region 128 is plotted, it is determined that the rechargeable batteries 18 have degraded to the stage at which they can no longer be utilized and that this degradation was abnormal. When a point such as V in the normally degraded region 126 is plotted, it is determined that the rechargeable batteries 18 have degraded to the stage at which they can no longer be utilized and that this degradation was normal. When a point such as W in the abnormally degrading region 124 is plotted, it is determined that the rechargeable batteries 18 are still in a state in which they can be further utilized, and it is determined that degradation is proceeding abnormally. When a point such as X in the normally degrading region 122 is plotted, it is determined that the rechargeable batteries 18 are in a state in which they can be further utilized, and it is determined that degradation is proceeding normally.

At step S 18, the degree of progress of degradation of the rechargeable batteries 18 is estimated. The degree of progress of degradation of the rechargeable batteries 18 is the extent to which the rechargeable batteries 18 have degraded at that juncture, relative to a state in which further utilization is not possible. For example, if the degree of progress of degradation is 50 percent, the rechargeable batteries 18 will degrade to the state in which utilization is not possible when they have been further used to the same extent as had been used up until that point.

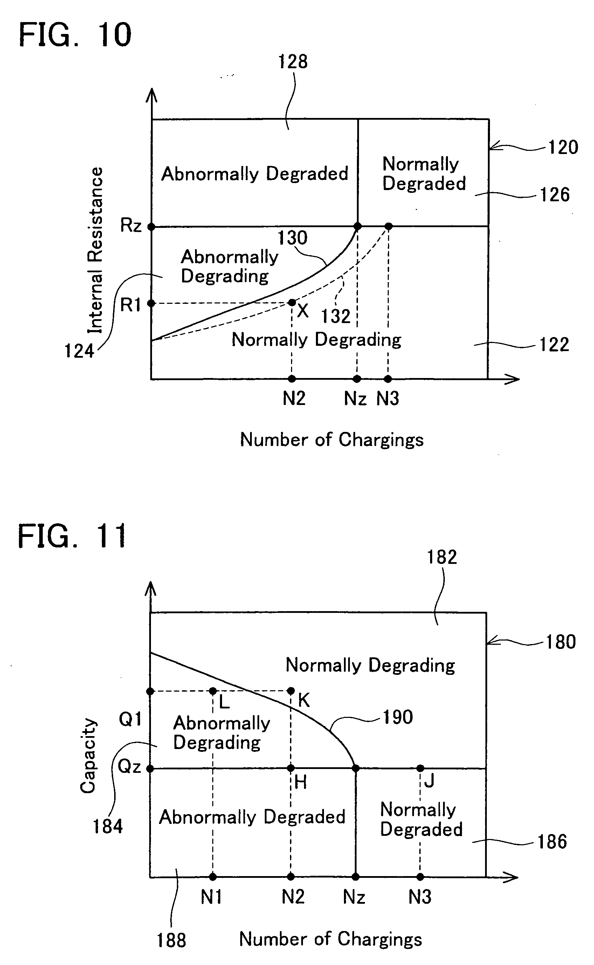

The process for estimating the degree of progress of degradation, which is performed by the diagnosis processing portion 90, will be described with reference to FIG. 10. As shown in FIG. 10, the diagnosis processing portion 90 looks up, on the internal resistance reference degradation map (LUT) 120 shown in FIG. 7, the pairs of values (i.e., the number of chargings of the rechargeable batteries 18 that was detected at step S4 and the internal resistance of the rechargeable batteries 18 that was detected at step S8). Here, a case is described in which the point X is plotted. Further, it should be noted that the number of chargings used in this process is not a number of chargings revised at step S 14. Using the plotted point X and the standard relationship curved line 130 stored in the internal resistance reference degradation map 120, the diagnosis processing portion 90 creates (predicts), on the internal resistance reference degradation map 120, a curved line of transitions 132 showing the number of chargings and internal resistance from that time onwards. In the curved line of transitions 132, the number of chargings N3 is found at which the internal resistance is expected to exceed the degradation reference resistance value Rz. That is, when the number of chargings of the rechargeable batteries 18 becomes N3, the internal resistance is expected to increase to the degradation reference resistance value Rz, and it is estimated (predicted) that the rechargeable batteries 18 will have degraded at N3 to the stage at which they can no longer be utilized. The diagnosis processing portion 90 then calculates, based upon the difference between the number of chargings N2 at that time and the estimated number of chargings N3 when irreparable degradation is expected to occur, the degree of progress of degradation.

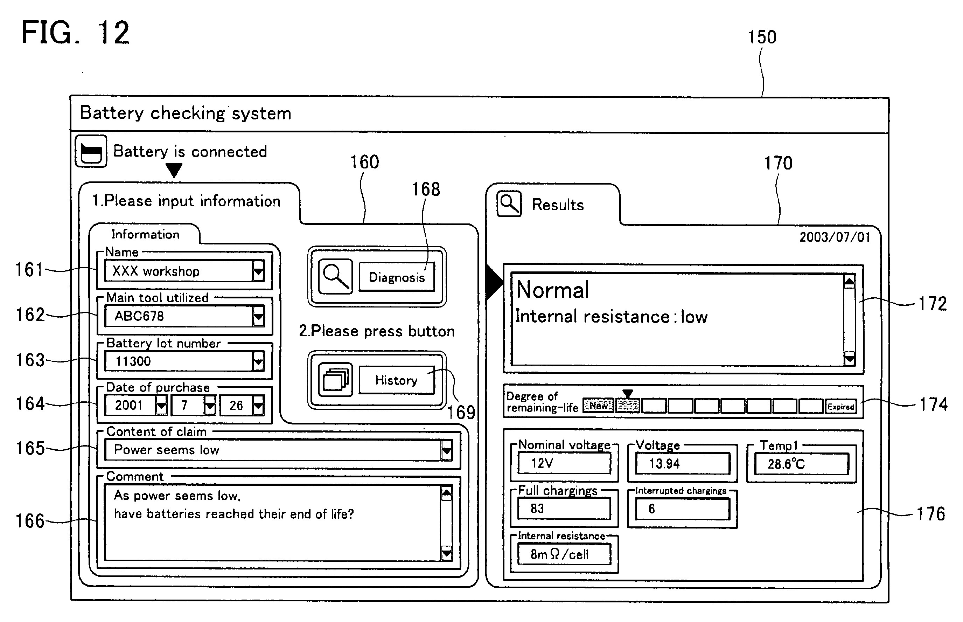

At step S20 of FIG. 9, the determined results, etc. of the above processes are indicated on the display 74. FIG. 12 shows an example of a display screen 150 displayed by the display 74. As shown in FIG. 12, the display screen 150 is principally composed of an input display 160 and a result display 170. The input display 160 displays a form for the user to input information and commands into the battery checking system 2. For example, with reference to the battery pack 10, the user can input: the owner (161), the model number or name of the equipment (power tool, etc.) (162), the production lot number (163), the date of purchase (164), a user evaluation (165), and the aim of the present diagnosis (166).

A diagnosis instructing button 168 and a history display button 169 are displayed on the input display 160, which buttons enable the user to input instructions into the battery checking system 2. A command to execute the diagnosing process for the battery pack 10 can be given to the battery checking system 2 by means of the diagnosis instructing button 168. Further, the diagnosing process of the battery pack 10 is begun, as described above, by connecting the battery pack 10 with the checking adapter 50 (step S2). The diagnosis instructing button 168 is utilized in cases where the battery pack 10 has already been connected, etc, such as the case where the same battery pack 10 is to be diagnosed repeatedly and/or continuously. The accumulated diagnostic information data 86 stored in the storage portion 80, which includes the previous diagnostic information of the battery pack 10, can be displayed on the result display 170 by clicking on the history display button 169.

The result display 170 displays the diagnosis results concerning the battery pack 10, and is composed of a diagnostic result comment display 172, a remaining-life display 174, and a detecting-value display 176. Comments based on the determined results from step S 10 concerning active/non-active, and step S16 concerning the state of degradation, are displayed in the diagnostic result comment display 172. If 'normally degrading' was diagnosed in step S16, for example, the word 'Normal' or the like will be displayed as shown in FIG. 12.

The degree of progress of degradation estimated in step S18 is displayed in the remaining-life display 174. Various detected values detected during the diagnosing process are displayed in the detecting-value display 176. For example, the nominal voltage values of the rechargeable batteries 18, the detected actual voltage values of the rechargeable batteries 18, the temperature of the rechargeable batteries 18 detected by the temperature sensor 23, etc. are displayed. Further, the number of chargings read from the EEPROM 21, the detected internal resistance values, etc. of the rechargeable batteries 18 are displayed.

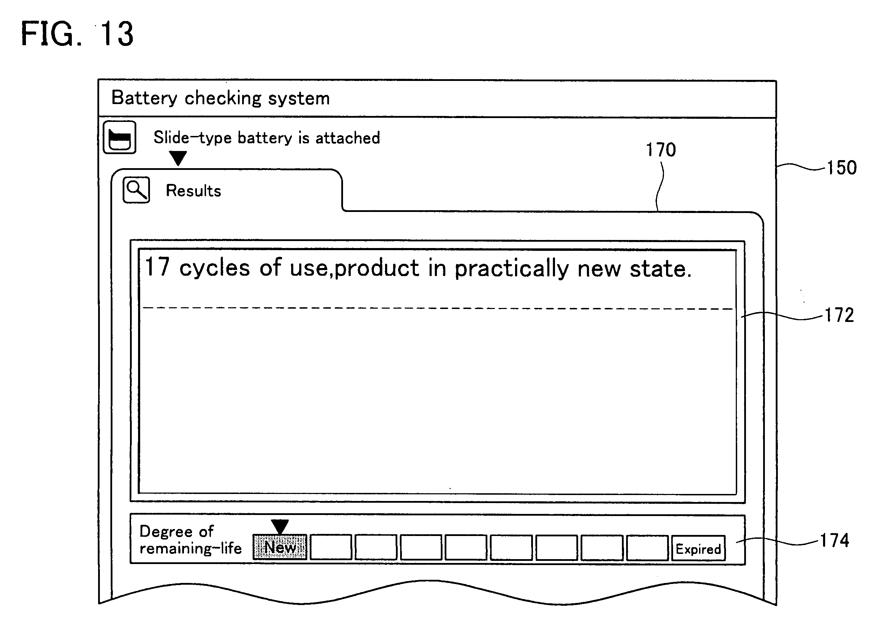

FIGS. 13, 14, 15, and 16 show exemplary indications of the result display 170. FIG. 13 shows an exemplary indication wherein the state of degradation of the rechargeable batteries 18 was determined to be 'normally degrading', the number of chargings was also relatively few, and the battery pack 10 was diagnosed as being new or substantially new. Performing diagnosis on the battery pack 10 when use has recently begun is effective for recognizing whether early failure has occurred due to manufacturing issues, or for similar reasons.

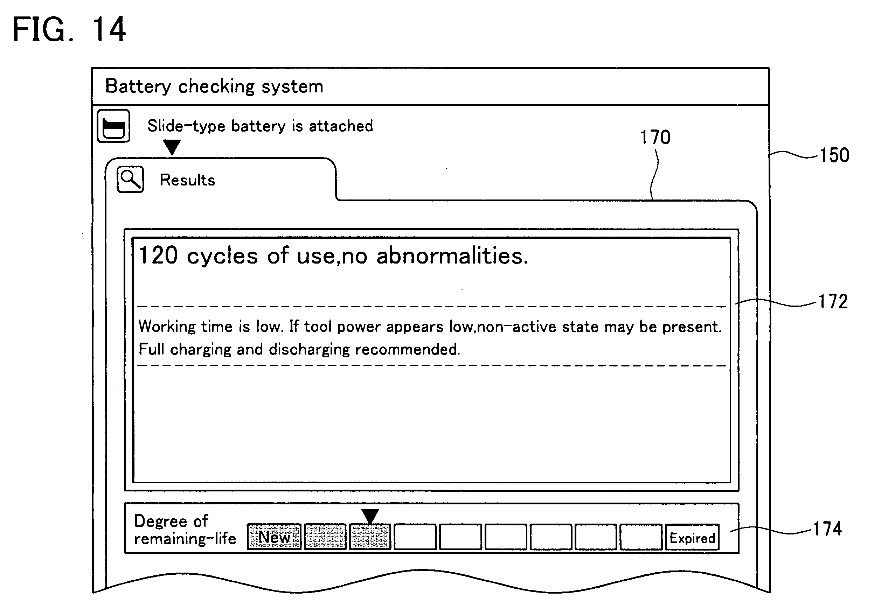

FIG. 14 shows an exemplary indication wherein the state of degradation of the rechargeable batteries 18 was determined to be 'non-active' in step S 10, and was determined to be 'normally degrading' after the refresh operation. As shown in FIG. 14, if the rechargeable batteries 18 were determined to be in the non-active state, a comment may be added recommending complete discharging, etc. (i.e., a refresh operation) followed by a full charging of the batteries 18 in order to restore the batteries 18 to the active state.

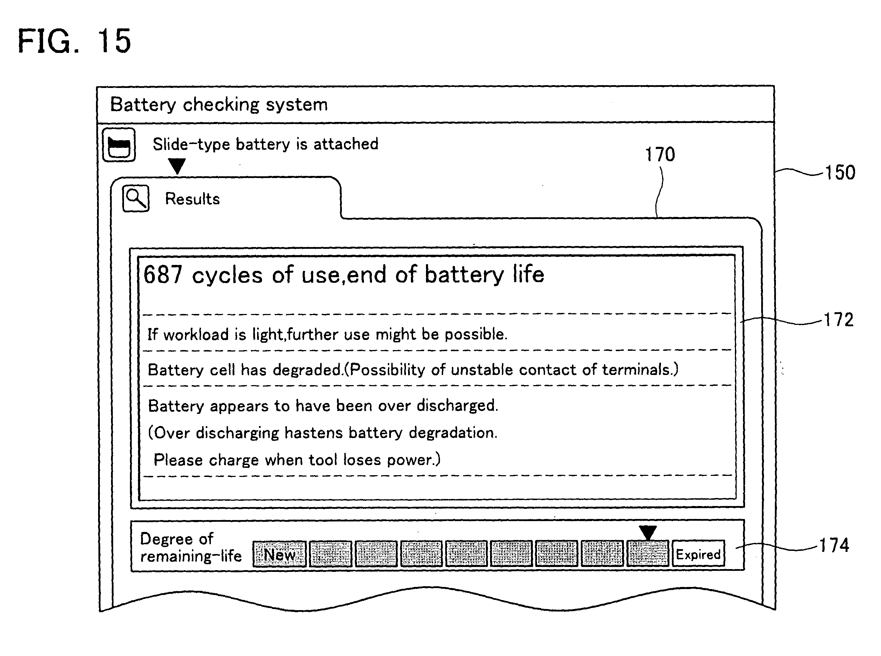

FIG. 15 shows an exemplary indication wherein the state of degradation of the rechargeable batteries 18 was determined to be 'normally degraded'. If it is ascertained, from the history of remaining quantity data stored in the EEPROM 21 of the battery pack 10, that over discharging has frequently occurred, the user of the battery pack 10 may be advised, as in FIG. 15, that 'Over discharging hastens battery degradation. Please charge when tool loses power'. In other words, the user can be recommended to re-charge the batteries 18 at an earlier stage of operation in order to prevent irreparable damage caused by over-discharging the batteries 18.

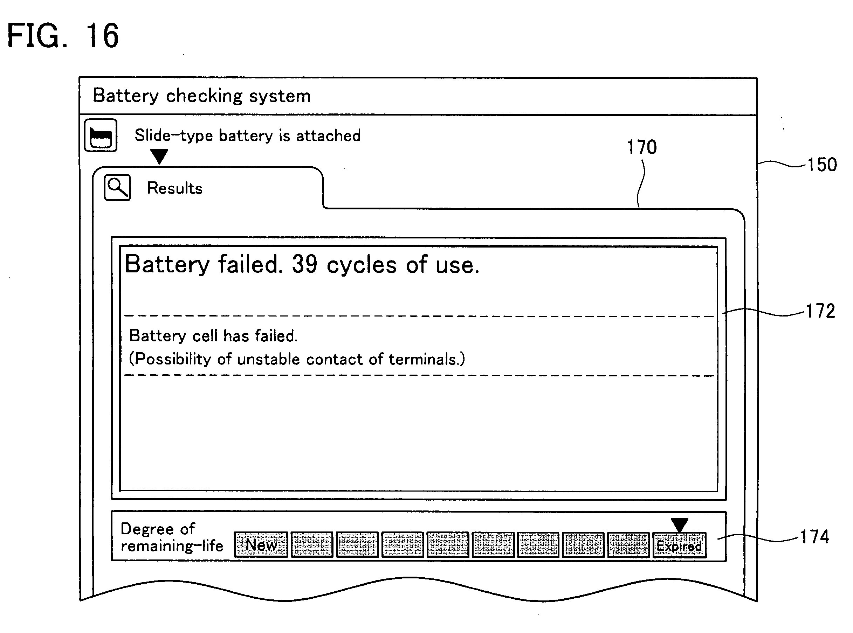

FIG. 16 shows an exemplary indication wherein the state of degradation of the rechargeable batteries 18 was determined to be 'abnormally degraded'. If the degradation of the rechargeable batteries 18 is abnormal and the number of chargings is low, failure of the battery pack 10 can be assumed to have occurred. If failure of the battery pack 10 is suspected, a notification is given as shown in FIG. 16, so as to prevent the continued use of the failed battery pack 10.

At step S22 of FIG. 9, the present diagnosis results are added to the accumulated diagnostic information data 86 stored in the storage portion 80. Here, the term 'diagnosis results' includes data read from the EEPROM 21 of the battery pack 10, detected voltage change patterns or temperatures of the rechargeable batteries 18, calculated charging/discharging capacity values and internal resistance values of the rechargeable batteries 18, determined results concerning the state of degradation, and information that was input by the user by means of the input display 160. The battery checking system 2 is capable of reading the diagnostic information stored in the accumulated diagnostic information data 86 and, as shown in FIGS. 12 to 16, displaying the display screen 150 of the diagnosis results on the display 74 at any time. Further, the battery checking system 2 is capable of reading the previous diagnostic data stored in the EEPROM 21 of the battery pack 10 and displaying this information on the display 74.

Moreover, at step S22, the present diagnosis results are written to the EEPROM 21 of the battery pack 10. Since the present diagnosis results are stored in the EEPROM 21 of the battery pack 10, the present diagnostic information can be displayed even when the battery pack 10 is diagnosed by a different battery checking system 2.

Based upon the above-described method, the battery checking system 2 is capable of determining whether the rechargeable batteries 18 are degrading normally or abnormally in relation to the number of chargings. Therefore, it is possible to prevent the continued use of a failed battery pack 10 and thereby prevent secondary failures such as damage to electrical equipment.

Furthermore, the battery checking system 2 is capable of estimating the degree to which the rechargeable batteries 18 have degraded relative to the expected end-life thereof. It is also possible to estimate the period of time until the rechargeable batteries 18 are expected to have degraded to the stage at which they can no longer be utilized, thereby enabling the user of the rechargeable batteries 18 to alter plans for future use of the battery pack 10.

Moreover, the battery checking system 2 is capable of estimating whether the battery pack 10 is being used in an inappropriate or sub-optimal manner that unnecessarily hastens the degradation of the rechargeable batteries 18. As a result, the user of the battery pack 10 is informed that the manner of utilization itself is promoting the unduly rapid degradation of the rechargeable batteries 18, thus enabling the future manner of utilization of the battery pack 10 to be improved.

At step S16, as described above, a process for determining the state of degradation of the rechargeable batteries 18 is performed that uses the value of the number of chargings relative to internal resistance. However, charging/ discharging capacity may be utilized in place of internal resistance. In that case, the reference degradation map (LUT) 180 relating to charging/ discharging capacity (shown in FIG. 11) should be utilized in place of the reference degradation map (LUT) 120 relating to internal resistance that is shown in FIG. 7.

As shown in FIG. 11, the reference degradation map 180 relating to charging/discharging capacity is a two-dimensional map wherein the number of chargings is indicated on the horizontal axis and the charging/ discharging capacity is indicated on the vertical axis. Similar to map 120, the reference degradation map 180 relating to the charging/ discharging capacity also has a "normally degrading" region 182, an "abnormally degrading" region 184, a "normally degraded" region 186, and an "abnormally degraded" region 188, which are determined on the basis of the relationship between the number of chargings and the charging/ discharging capacity. The curved line 190 separates the normally degrading region 182 from the abnormally degrading region 184 and represents the standard (normal) relationship between the number of chargings and the charging/ discharging capacity of degrading rechargeable batteries 18 in the case where the manufacture and use of the battery pack 10 is normal. The charging/ discharging capacity value Qz shown in FIG. 11 is a degradation reference capacity value Qz. Further, the number of chargings Nz is a reference number of chargings Nz. When the rechargeable batteries 18 have been utilized normally (e.g., optimally), the charging/ discharging capacity thereof is predetermined not to be less than the degradation reference capacity value Qz at this reference number of chargings Nz.

In the reference degradation map 180 relating to charging/ discharging capacity, the normally degrading region 182 is a region wherein the charging/ discharging capacity relative to the number of chargings is equal to or above a standard value, which indicates that the rechargeable batteries 18 are degrading normally relative to the number of chargings. The abnormally degrading region 184 is a region wherein the charging/ discharging capacity relative to the number of chargings is below the standard value, which indicates that the rechargeable batteries 18 are degrading abnormally. The normally degraded region 186 is a region wherein the number of chargings is equal to or above the reference number of chargings Nz and the charging/ discharging capacity is equal to or below the degradation reference capacity value Qz, which indicates that the rechargeable batteries 18 have degraded normally to the stage at which they can no longer be utilized. The abnormally degraded region 188 is a region wherein the number of chargings is less than the reference number of chargings Nz and the charging/ discharging capacity is equal to or below the degradation reference charging/ discharging capacity value Qz, which indicates that the rechargeable batteries 18 have degraded abnormally to the stage at which they can no longer be utilized.

The reference degradation map 180 may be added to and stored in the reference data 82 (FIG. 6).

The diagnosis processing portion 90 looks up, on the reference degradation map 180 relating to charging/ discharging capacity that is shown in FIG. 11, the detected pair of values (i.e., the number of chargings of the rechargeable batteries 18 that was revised at step S 14 of FIG. 9 and the charging and discharging of the rechargeable batteries 18 that was detected at step S6), thereby enabling the state of degradation of the rechargeable batteries 18 to be determined. As shown in FIG. 11, when for example a point such as K in the normally degrading region 182 is plotted, it is determined that the rechargeable batteries 18 are in the state in which they can be further utilized, and it is determined that degradation is proceeding normally. When a point such as L in the abnormally degrading region 184 is plotted, it is determined that the rechargeable batteries 18 are still in the state in which they can be further utilized, but it is also determined that degradation is proceeding abnormally. When a point such as J in the normally degraded region 186 is plotted, it is determined that the rechargeable batteries 18 have degraded to the stage at which they can no longer be utilized and that this degradation was normal. When a point such as H in the abnormally degraded region 188 is plotted, it is determined that the rechargeable batteries 18 have degraded to the stage at which they can no longer be utilized and that this degradation was abnormal.

As was discussed above with respect to FIG. 6, it is possible to connect the battery checking system 2 with the internet by means of the internet connecting portion 96, such that information is exchanged with one or more external computer devices, etc. via the internet. For example, the battery checking system 2 is capable of receiving new reference data 82 or the like from an external computer device.

The battery checking system 2 is also capable of sending the accumulated diagnostic information data 86 stored in the storage portion 80 to the external computer device. By this means, the user of the battery checking system 2 can ask for advice from, and send diagnostic information of the battery pack 10 to, a person or organization that possesses detailed information concerning the battery pack 10 (for example, the supplier of the battery pack 10).

### EMBODIMENT 2

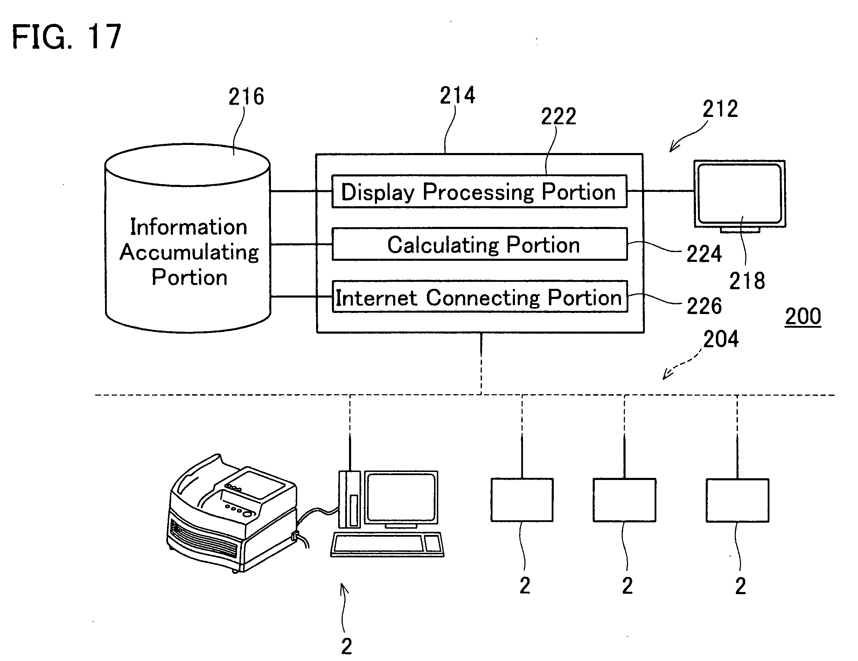

FIG. 17 shows the configuration of a battery checking network 200 of the present embodiment. As shown in FIG. 17, the battery checking network 200 comprises a host computer 212 and a plurality of battery checking systems 2 of Embodiment 1. The host computer 212 and the battery checking systems 2 are connected via the internet 204 or another wired or wireless network.

The host computer 212 is provided with a processing portion 214 (e.g., a controller or processor) for performing process operations (executing one or more programs) of the host computer 212, a diagnostic information accumulating portion 216 for accumulating and storing diagnostic information of the battery pack 10, a display 218 for displaying the information input from the processing portion 214, etc.

The processing portion 214 has a display processing portion 222 for creating and outputting the displayed information displayed on the display 218, a determination reference calculating portion 224 for calculating determination references of the rechargeable batteries 18 from the diagnostic information stored in the diagnostic information accumulating portion 216, and an internet connecting portion 226 that connects the host computer 212 with the internet and allows the exchange of electronic information with the battery checking systems 2, etc.

The battery checking systems 2 of Embodiment 1 may serve as a plurality of diagnosing devices at each terminal of the battery checking network 200 and may operate as described in Embodiment 1 to diagnose a plurality of battery packs 10. Here, the plurality of battery checking systems 2 of the present embodiment are connected with the internet 204 by means of the internet connecting portion 96, and are set so as to be connected when the host computer 212 searches in the internet 204.

The battery checking systems 2 send the diagnostic information obtained by performing diagnosis of the battery pack 10 to the host computer 212 via the internet 204. The battery checking systems 2 may send the diagnostic information each time diagnosis of the battery pack 10 is performed, or may store diagnostic information in the accumulated diagnostic information data 86 and send this data in bulk.

The host computer 212 stores the diagnostic information sent from the battery checking systems 2 in the diagnostic information accumulating portion 216. The diagnostic information accumulating portion 216 accumulates and stores numerous items of diagnostic information sent from numerous battery checking systems 2. Diagnostic information relating to the battery packs 10 in a variety of usage environments is accumulated in the diagnostic information accumulating portion 216.

The nature of the degradation of the rechargeable batteries 18 can be examined by evaluating the diagnostic information stored in the diagnostic information accumulating portion 216, and further information is accumulated for the purpose of diagnosis. The diagnostic information that has been accumulated can be displayed on the display 218 by means of the display processing portion 222, and can be evaluated.

The determination reference calculating portion 224 is capable of calculating determination references of the rechargeable batteries 18 from the diagnostic information accumulated and stored in the diagnostic information accumulating portion 216. For example, the determination reference calculating portion 224 extracts a plurality of values of pairs of charging numbers and internal resistances from the plurality of items of stored diagnostic information, and plots these values on a two-dimensional map of number of chargings relative to internal resistance. It is possible, from the distribution of the plotted points, to map the normally degrading region 122, the abnormally degrading region 124, the normally degraded region 126, the abnormally degraded region 128, etc. of the reference degradation map 120 relating to internal resistance shown in FIG. 7, and thereby to form anew the internal resistance reference degradation map 120. Similarly, the reference activity map 140 and the reference degradation map 180 relating to charging/ discharging capacity can be formed anew. The reference data created in this manner reflects a plurality of cases wherein the rechargeable batteries 18 are in a variety of usage environments, and it is possible to determine the degradation of the rechargeable batteries 18 more precisely using this reference data.

The reference data of the reference degradation map 120 relating to internal resistance, the reference activity map 140, the reference degradation map 180 relating to charging/ discharging capacity, etc., all these being determined by the determination reference calculating portion 224, are sent to the battery checking systems 2 via the internet 204. The battery checking systems 2 update the reference data 82 stored in the storage portion 80 with the new reference data that was sent.

One manner of using the battery pack 10 is to provide a plurality of battery packs 10 for consecutively driving a power tool, i.e., one battery pack 10 is replaced by a different fully charged battery pack 10 when its charged power is exhausted, and then the power tool operation is continued. The exhausted battery pack 10 may be immediately recharged in order to prepare it for its next use. This manner of use is frequently adopted for, for example, factory assembly lines, etc. In this manner of use, it is necessary to calculate the parameters of the workload, the number of power tools, the period of operation of one battery pack 10, the period of charging required for one battery pack 10, etc. in order to determine the optimal number of battery packs 10 that are required for continuous operation of the power tool. If the number of battery packs 10 provided is too few, the problem readily occurs that the battery packs 10 are used for too long of a period of time during each individual operation before recharging and the rechargeable batteries 18 thereof are over discharged, which results in the power tools having an unstable output. If the number of battery packs 10 provided is too many, on the other hand, the problem readily occurs that each of the battery packs 10 is used for too short of a period of time during each individual operation before recharging, and thus the recharging is begun before the rechargeable batteries 18 have been sufficiently discharged, thereby making the rechargeable batteries 18 susceptible to become "non-active." It is difficult to correctly determine the optional number of battery packs 10 required for continuous operation of the power tool, and it is also difficult to determine whether the number of battery packs 10 provided was correct. However, unless the required number of battery packs 10 is determined correctly, the user of the battery packs 10 cannot effectively utilize the battery packs 10. In this case, the user of the battery packs 10 may incorrectly assume that the battery packs 10 have an excessively small capacity, which may adversely affect the user's relationship with the supplier of the battery pack 10.

The battery checking network 200 is also useful in dealing with the above problem. In order to resolve this problem, those with detailed information concerning the battery pack 10 (the suppliers or the like) can construct the battery checking network 200, which would comprise the host computer 212 that allows access, and the battery checking systems 2 that are provided at the site where the battery packs 10 are utilized.

As a hypothetical example, assume that a user utilizes a plurality of battery packs 10 under the same conditions of use, the user feels that the speed of degradation of the battery packs 10 is too fast and performs a diagnosis of the battery packs 10 by means of the battery checking systems 2. This diagnosis shows that all the battery packs 10 have degraded abnormally. If a plurality of battery packs are utilized under the same conditions and undergo the same diagnosis, it will be suspected that abnormal degradation is caused not by an abnormality (defect) of the battery packs 10, but by the manner of use. However, given the user's knowledge of the battery packs 10, it is difficult to discover the problem concerning the manner of use and to improve the manner of use.

In the battery checking network 200, the diagnostic information concerning the battery packs 10 that have been diagnosed by the battery checking systems 2 is sent to the host computer 212. At this time, the form shown in FIG. 12 can be filled in as was described above. Further, in the comment input columns 165 and 166, it is possible to input the relationship between the number of power tools and the number of battery packs 10, details of the operations, operating periods, etc. The diagnostic information can be transmitted in real time by means of the internet, such that there is no need to send the battery pack 10 itself.

The supplier (or another entity) of the battery pack 10 is then capable of estimating (predicting) the manner of use of the battery packs 10 from the sent diagnostic information concerning the battery packs 10. For example, if it is ascertained from the history of remaining quantity data of the battery packs 10 that the battery packs 10 are frequently over discharged, it is possible to predict that an insufficient number of battery packs 10 were utilized. Alternatively, if it can be seen that the battery packs 10 generally tend towards the "non-active" state, it is possible to predict that too many battery packs 10 were utilized. These estimations can be substantiated by means of other sent diagnostic information, such as for example correspondence between the model of battery pack 10 and the model of the power tool, details of operations, operating periods, etc. The suppliers or the like of the battery packs 10 can give suggestions to the user for improving the manner of use of the battery packs 10, such as increasing or decreasing the number of battery packs 10, alterations to the power tool, etc. In this manner, it is possible for the user of the battery packs 10 to receive diagnosis from the suppliers or the like of the battery packs 10 by means of the battery checking network 200, which diagnosis concerning the manner of use of the battery packs 10. Further, it is possible for the suppliers or the like of the battery packs 10 to give suggestions to the users for improving the manner of use of the battery packs 10. After the users of the battery packs 10 have improved the manner of use of the battery packs 10 based on the diagnosis from the suppliers or the like of the battery packs 10, the users may again perform diagnosis of the battery packs 10 by means of the battery checking systems 2, and may send this diagnostic information to the suppliers of the battery packs 10. The suppliers of the battery packs 10 can thus confirm the results of the proposed suggestions by means of the received diagnostic information, thereby improving the relationship with the user.

The battery checking network 200 described above is also useful in the example described below.

The battery packs 10 are charged based on the charging characteristics data stored in the EEPROM 21. The charging characteristics data determines the appropriate charging current(s) and the necessary frequency of refresh operations on the basis of the characteristics, etc. of the rechargeable batteries 18, such that the full capacities of the rechargeable batteries 18 are maintained even after a plurality of charging and discharging cycles.

The manner of use of the battery packs 10 is not necessarily the same for each individual battery pack 10, and the charging characteristics data stored in the EEPROM 21 is not necessarily most suited for the rechargeable batteries 18 of each battery pack 10. For example, a battery pack 10 utilized in a charging and discharging cycle, wherein the battery pack 10 is charged to a fully charged state after adequate discharging, will not readily enter the non-active state, and consequently will rarely need a refresh operation. It is possible to reduce the degradation of the rechargeable batteries 18 in this type of battery pack 10 by reducing the frequency of the refresh operations. Since refresh operations are time-consuming, many users also wish to reduce their frequency. Other users may wish to complete the charging within a short period of time, even though this "quick charging" may contribute to hastening the degradation of the rechargeable batteries 18. In this manner, individual characteristics concerning the charging process of the battery pack 10 frequently differ not only in accordance with the characteristics of the rechargeable batteries 18, but also in the manner of use. Conventionally, charging characteristics data providing the greatest common factor for a variety of manners of usage was applied uniformly to all battery packs 10.

If the user of the battery packs 10 wishes to revise the provisions concerning the charging process of the battery packs 10, the battery packs 10 are diagnosed by the battery checking systems 2. Again, the form shown in FIG. 12 may be filled in. Further, in the comment input columns 165 and 166, the manner of use of the battery packs 10, the desired characteristics of the battery packs 10, etc also can be input. For example, it is possible to input 'I want to reduce the frequency of refresh operations', or the like. This diagnostic information of the battery packs 10 is sent to the host computer 212. Since this information is sent via the internet 204, the diagnostic information can be transmitted in real time even to the remote host computer 212, such that there is no need to send the battery packs 10 to the supplier for evaluation.

The supplier of the battery packs 10 can ascertain the charging characteristics data of the battery packs 10 from the diagnostic information of the battery packs 10 sent to the host computer 212. Further, the supplier can ascertain the state of degradation, the manner of use, etc. of the battery packs 10. Furthermore, it is possible for the supplier to ascertain the characteristics of the battery packs 10 desired by the users.

The suppliers of the battery packs 10 determine whether the charging characteristics data of the battery packs 10 are suitable by diagnosing the actual state of degradation of the battery packs 10 together with the manner of use. For example, in the case where over discharge frequently occurs without any indication of non-active status on the part of the rechargeable batteries 18, it can be diagnosed that the frequency of the refresh operation should be reduced. If the user wishes to reduce the frequency of refresh operations, it is possible to ascertain whether this measure is appropriate for the battery packs 10. The supplier of the battery packs 10 may send charging characteristics data for reducing the frequency of refresh operations from the host computer 212 to the battery checking systems 2. The new charging characteristics data that the battery checking systems 2 have received is sent to the control portion 61 of the checking adapter 50, and the control portion 61 replaces the charging characteristics data stored in the EEPROM 21 of the battery pack 10 with the new charging characteristics data. The battery pack 10 that has been updated with the charging characteristics data reduces the frequency at which refresh operations are caused to be performed.

### EMBODIMENT 3

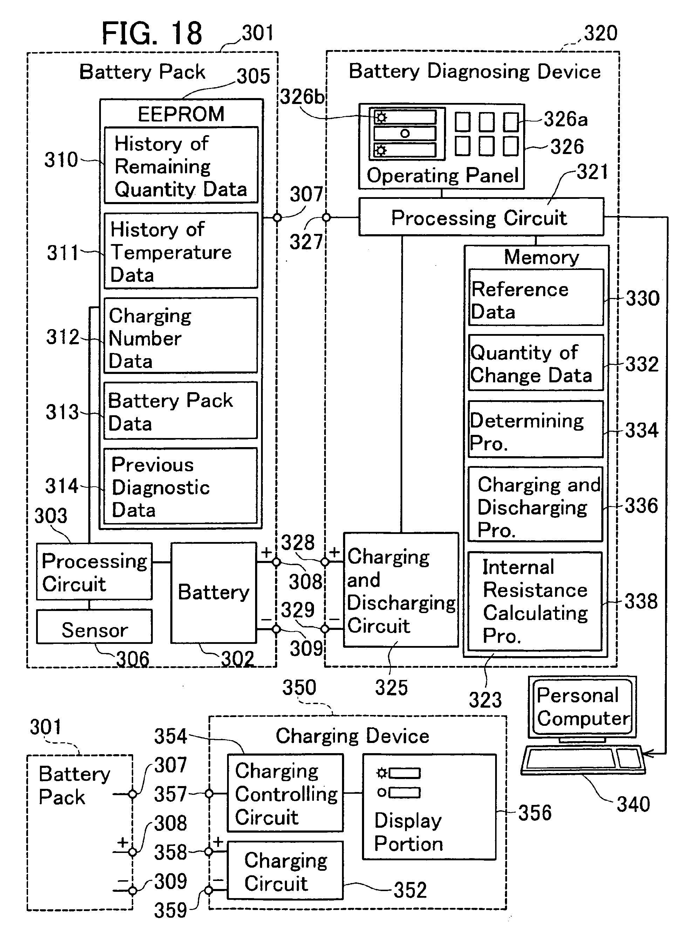

A different battery diagnosing device will now be described. FIG. 18 shows a battery pack 301, a battery diagnosing device 320 of the present embodiment for performing diagnosis of the battery pack 301, and a personal computer 340 connected with the battery diagnosing device 320.

The battery pack 301 is provided with a rechargeable battery 302 capable of being recharged repeatedly. The battery pack 301 is provided with a processing circuit 303, an EEPROM 305, and a temperature sensor 306. Further, the battery pack 301 is provided with a memory terminal 307 to be electrically connected with the exterior, a plus terminal 308, and a minus terminal 309. The memory terminal 307 is electrically connected with the EEPROM 305. The plus terminal 308 is electrically connected with a positive pole of the battery 302. The minus terminal 309 is electrically connected with a negative pole of the battery 302.

The EEPROM 305 stores the history of the remaining quantity data 310, the temperature history data 311, the charging number data 312, battery pack data 313, and previous diagnostic data 314. These data are the same as those of the battery checking system 2.

The battery diagnosing device 320 is provided with a processing circuit 321 for performing processes (executing programs) relating to diagnosis, a memory 323 for storing data and programs utilized in the processing of the processing circuit 321, a charging and discharging circuit 325 for performing the charging and discharging of the battery 302 of the battery pack 301 to be diagnosed, and an operating panel 326 by means of which the user operates the battery diagnosing device 320 and on which information is displayed to the user.

The memory 323 stores reference data 330 for determining the state of degradation of the battery 302. The reference data 330 includes one or more of the reference degradation map 120 relating to the internal resistance shown in FIG. 7, the reference activity map 140 shown in FIG. 8, the reference degradation map 180 relating to charging/ discharging capacity shown in FIG. 11, etc.

The memory 323 stores the quantity (number) of change data 332 that can be utilized to calculate how many further charging and discharging cycles can be performed on the battery 302 after diagnosis until complete degradation (i.e., irreparable degradation) occurs (hereafter, the number of charging and discharging cycles is referred to as the "number of remaining chargings"). The quantity of change data 332 is preferably composed of (i) the quantity (amount) of decline (decrease) of capacity data, i.e., the amount of reduction of charging/ discharging capacity relative to the number of chargings of the battery 302, the quantity (amount) of increase of internal resistance data, i.e., the amount that the internal battery resistance has increased relative to the number of chargings of the battery 302, etc. In the quantity of decline of capacity data, the smaller the unit quantity that is used for storing the number of chargings, the more precisely the number of remaining chargings can be measured. However, the smaller the unit quantity for storing the performed number of chargings in the quantity of decline of capacity data, the greater the quantity of data is stored. To deal with this, the unit quantity used for storing the number of chargings in the quantity of decline of capacity data could be set so as to correspond to the method to be implemented. The same applies to the quantity of increase of internal resistance data.

The memory 323 stores a determining program 334 for determining the state of degradation of the battery 302, which program is executed by the processing circuit 321.

The memory 323 also preferably stores a charging and discharging program 336 that is executed by the processing circuit 321 when the battery 302 (this having been connected) is to be charged or discharged.

The memory 323 also preferably stores an internal resistance calculating program 338 that is executed by the processing circuit 321 to measure the internal resistance of the battery 302.

The charging and discharging circuit 325 is controlled by the processing circuit 321 and performs charging and discharging of the battery 302. For example, the processing circuit 321 preferably utilizes the charging and discharging program 336 stored in the memory 323. The battery diagnosing device 320 is capable of charging and discharging the battery 302 by means of the charging and discharging circuit 325, and is capable of measuring the internal resistance of the battery 302. From the current values and voltage values detected by the charging and discharging circuit 325 during charging and discharging, the battery diagnosing device 320 utilizes the internal resistance calculating program 338 to calculate internal resistance. Further, the charging and discharging circuit 325 is capable of measuring the charging/ discharging capacity of the battery 302 after the battery 302 has been connected, has been fully charged, and then fully discharged.

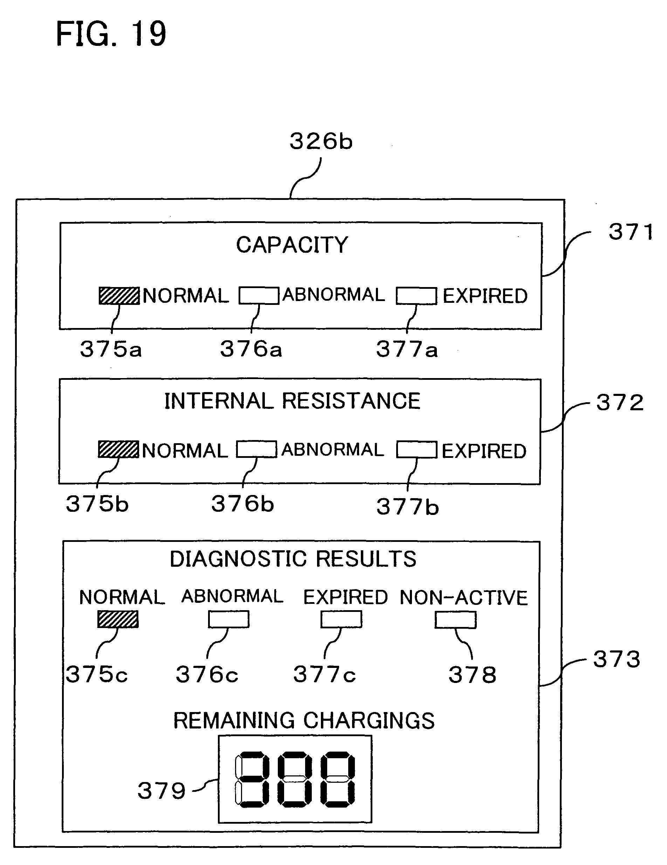

The operating panel 326 is provided with a switch 326a, etc. for operating the battery diagnosing device 320, and a result display portion 326b on which diagnostic results are displayed. As shown in FIG. 19, the result display portion 326b is provided with a first display portion 371, a second display portion 372, and a third display portion 373. The first display portion 371 displays the results of a first diagnosis that utilizes the charging/discharging capacity and the number of chargings. The second display portion 372 displays the results of a second diagnosis that utilizes the internal resistance and the number of chargings. The third display portion 373 displays the combined results wherein the results of the first diagnosis and the results of the second diagnosis are combined. Moreover, the third display portion 373 displays the estimated number of remaining chargings.

The first display portion 371 is provided with an LED 375a, an LED 376a, and an LED 377a, which is illuminated to display diagnostic results. The second display portion 372 is provided with an LED 375b, an LED 376b, and an LED 377b that display diagnostic results. The third display portion 373 is provided with an LED 375c, an LED 376c, an LED 377c, and an LED 378 that display diagnostic results. Further, the third display portion 373 is provided with the LED 378 and a three-column, seven-segment LED 379.

The battery diagnosing device 320 is provided with a data terminal 327, a plus output terminal 328, and a minus output terminal 329. The connecting terminals 327 to 329 are connecting terminals for establishing an electrical connection with the battery pack 301. The data terminal 327 is electrically connected with the processing circuit 321. The plus output terminal 328 is electrically connected with a positive pole output of the charging and discharging circuit 325. The minus output terminal 329 is electrically connected with a negative pole output of the charging and discharging circuit 325. When the battery pack 301 is connected with the battery diagnosing device 320, the memory terminal 307 of the battery pack 301 and the data terminal 327 of the battery diagnosing device 320 are electrically connected, the plus terminal 308 of the battery pack 301 and the plus output terminal 328 of the battery diagnosing device 320 are electrically connected, and the minus terminal 309 of the battery pack 301 and the minus output terminal 329 of the battery diagnosing device 320 are electrically connected.

Furthermore, the processing circuit 321 of the battery diagnosing device 320 can be connected with the personal computer 340.

A charging device 350 charges the battery 302 of the battery pack 301. The charging device 350 is provided with a charging circuit 352 for supplying power (current) to the battery 302 of the battery pack 301, a charging controlling circuit 354 for controlling the charging circuit 352, and a display portion 356 for displaying the operating state of the charging device 350. Further, the charging device 350 is provided with a data terminal 357, a plus output terminal 358, and a minus output terminal 359, which are connecting terminals for establishing an electrical connection with the battery pack 301. The data terminal 357 and the charging controlling circuit 354 are electrically connected. The plus output terminal 358 is electrically connected with a positive pole output of the charging circuit 352. The minus output terminal 359 is electrically connected with a negative pole output of the charging circuit 352.

When the battery pack 301 is connected with the charging device 350, the charging device 350 and the battery pack 301 are electrically connected and the battery 302 is charged. At this juncture, the charging controlling circuit 354 updates the charging number data 312 stored in the EEPROM 305 of the battery pack 301.

Within the battery pack 301, during charging, the processing circuit 303 adds the charging current of the battery 302, calculates, over time, the remaining quantity of the battery 302, and sends this data to the history of remaining quantity data 310 of the EEPROM 305. Moreover, the temperature of the battery 302 is calculated over time by the temperature sensor 306, and this data is stored in the history of temperature data 311 of the EEPROM 305.

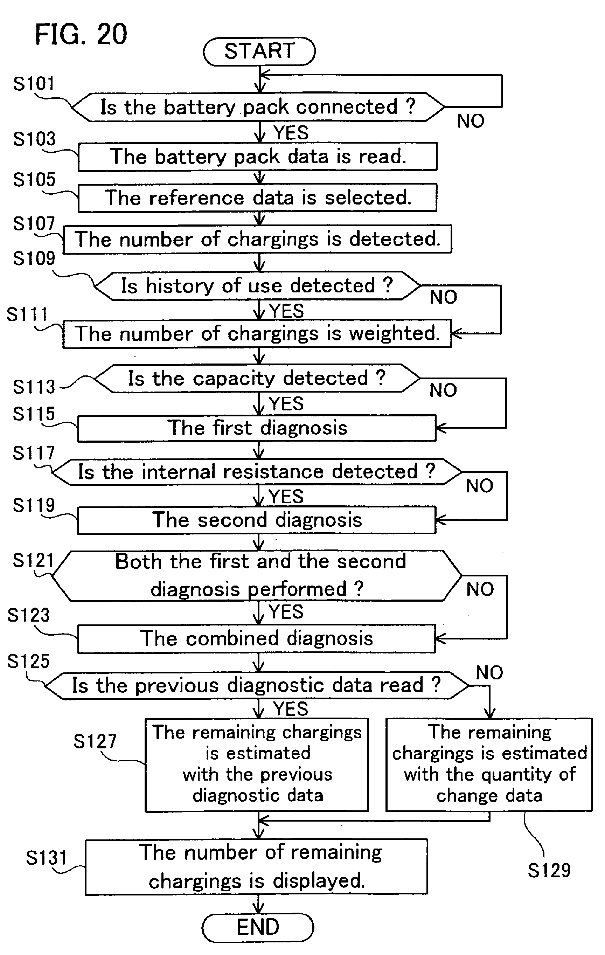

FIG. 20 is a flowchart showing the sequence of operation of the battery diagnosing device 320. The process shown in the flowchart of FIG. 20 is started by attaching the battery diagnosing device 320 to a power source, etc. The processing circuit 321 of the battery diagnosing device 320 begins to execute the determining program 334.

At step S101, the battery diagnosing device 320 is in a waiting state prior to having the battery pack 301 connected therewith.

At step S103, the stored data concerning the specification and characteristics of the battery pack 301 are detected (i.e., read and/or downloaded). The processing circuit 321 of the battery diagnosing device 320 reads the battery pack data 313 of the battery pack 301. If the battery pack data 313 of the battery pack 301 can no longer be read, the user may input information by means of the operating panel 326.

At step S105, the reference data for determining degradation is selected. On the basis of the battery pack data 313 of the battery pack 301 detected at step S103, the most suitable determination references for diagnosing the battery 302 are selected from the reference data 330 stored in the memory 323. If the specification and characteristics of the battery pack 301 were not detected, predetermined universal determination references may be utilized. However, it is preferable that the determination references are selected on the basis of the specification and characteristics of the particular battery pack 301. Here, the determination references corresponding to the battery pack 301 are selected to be one or more of the reference degradation map 120 relating to internal resistance shown in FIG. 7, the reference activity map 140 shown in FIG. 8, and the reference degradation map 180 relating to charging/ discharging capacity shown in FIG. 11.

At step S107 of FIG. 20, the number of chargings of the battery 302 is detected (i.e., read and/or downloaded). The processing circuit 321 reads the charging number data 312 stored in the EEPROM 305 of the battery pack 301.

At step S109, the history of use of the battery 302 is detected (i.e., read and/or downloaded). The processing circuit 321 reads the history of remaining quantity data 310 and the temperature history data 311 stored in the EEPROM 305 of the battery pack 301. The history of causes of degradation (such as over discharging, overly rapid charging etc. of the battery 302) is extracted from the history of remaining quantity data 310 that was read. Moreover, the history of causes of degradation, such as deviations from the prescribed temperature range, is extracted from the history of temperature data 311 that was read. Based upon the remaining quantity and the temperature history data that was extracted, it is determined whether the history of use of the battery 302 is 'normal' or 'rigorous'. For example, if the number of over dischargings and/or the number of overly rapid chargings exceeds a predetermined number, the history of use of the battery 302 may be determined to be 'rigorous'. In addition or in the alternative, when the frequency of use (or number of uses) outside the prescribed temperature range is equal to or above a predetermined limit, the history of use of the battery 302 also may be determined to be 'rigorous'. When the history of use of the battery 302 is not detected at step S109, the process proceeds to step S113.

At step S111, the detected actual number of chargings is weighted using the history of use of the battery 302 detected at step S109. If the history of use was determined to be 'rigorous' in step S109, the detected number of chargings is weighted. An example of the weighting process is to multiply by 1.5 the detected (actual) number of chargings. Thus, in the battery diagnosing device 320 of the present embodiment, when the history of use is 'rigorous', the number of chargings detected in step S107 is preferably revised so as to be weighted by 1.5 times the actual number. On the other hand, if the history of use is 'normal', the number of chargings is not revised. In the description below, an example is given wherein the history of use is 'normal'. Furthermore, in the case where the detection of the history of use of the battery 302 is not performed at step S109, weighting is not given to the number of chargings at step S111, but diagnosis is still performed in the manner described below.

At step S 113, the charging/ discharging capacity of the battery 302 is detected. The processing circuit 321 reads the history of remaining quantity data 310 stored in the EEPROM 305 of the battery pack 301. The charging/ discharging capacity of the battery 302 is the most recent maximum value of the history of remaining quantity data 310. If it is not possible to read the history of remaining quantity data 310, the battery 302 may be fully discharged after having been fully charged, and the discharging quantity is measured by means of the battery diagnosing device 320. The charging/ discharging capacity of the battery 302 that has been detected is related to the number of chargings detected at step S107, and is stored in the previous diagnostic data 314 of the EEPROM 305 of the battery pack 301. When the charging/ discharging capacity of the battery 302 has been detected, the process proceeds to step S115. When the charging/ discharging capacity of the battery 302 has not been detected, the process proceeds to step S 117.

At step S115, the first diagnosis is performed by utilizing the number of chargings of the battery 302 detected at step S 107 or the number of chargings revised at step S111, and the detected charging/ discharging capacity of the battery 302. In the first diagnosis, the reference degradation map 180 relating to charging/ discharging capacity shown in FIG. 11 is utilized. It is determined, by means of the first diagnosis, whether the state of degradation of the battery 302 of the battery pack 301 is 'abnormally degraded', 'normally degraded', 'abnormally degrading', or 'normally degrading'.

The results of the first diagnosis are displayed on the result display portion 326b of the operating panel 326. For example, the diagnostic results may be displayed by means of illuminating certain LEDs (i.e., LEDs 375a, 376a, or 377a) of the capacity diagnosis display portion 371. If the state of degradation of the battery 302 was diagnosed to be 'normally degrading', only the LED 375a is illuminated. If the state of degradation of the battery 302 was diagnosed to be 'abnormally degrading', only the LED 376a is illuminated. If the state of degradation of the battery 302 was diagnosed as being 'normally degraded', only the LED 377a is illuminated. If the state of degradation of the battery 302 was diagnosed as being 'abnormally degraded', both the LED 376a and the LED 377a are illuminated. The user of the battery diagnosing device 320 is thereby informed of the results of the first diagnosis.

At step S 117, the internal resistance of the battery 302 is measured by the battery diagnosing device 320. The detected internal resistance of the battery 302 is related to the number of chargings detected at step S107, and is stored in the previous diagnostic data 314 of the EEPROM 305 of the battery pack 301. At step S 117, when the internal resistance of the battery 302 has been detected, the process proceeds to step S 119. When the internal resistance of the battery 302 has not been detected, the process proceeds to step S121.

At step S119, the second diagnosis is performed by utilizing the number of chargings of the battery 302 detected at step S107 or the number of chargings revised at step S111, and the detected internal resistance of the battery 302. In the second diagnosis, the reference degradation map 120 relating to internal resistance shown in FIG. 7 is utilized. It is determined, by means of the second diagnosis, whether the state of degradation of the battery 302 of the battery pack 301 is 'abnormally degraded', 'normally degraded', 'abnormally degrading', or 'normally degrading'.

The results of the second diagnosis are displayed on the result display portion 326b of the operating panel 326. Similarly, the diagnostic results may be displayed by means of illuminating certain LEDs (i.e., LEDs 375b, 376b, or 377b) of the internal resistance diagnosis display portion 372. If the state of degradation of the battery 302 was diagnosed as being 'normally degrading', only the LED 375b is illuminated. If the state of degradation of the battery 302 was diagnosed as being 'abnormally degrading', only the LED 376b is illuminated. If the state of degradation of the battery 302 was diagnosed as being 'normally degraded', only the LED 377b is illuminated. If the state of degradation of the battery 302 was diagnosed as being 'abnormally degraded', both the LED 376b and the LED 377b are illuminated. The user of the battery diagnosing device 320 is thereby able to know the results of the second diagnosis.

The first diagnosis and the second diagnosis described above are independent and do not operate in tandem until step S 119. As a result, it is possible to know whether the degradation of the battery 302 is normal or abnormal using only the first diagnosis that utilizes the charging/ discharging capacity and the number of chargings. Moreover, it is possible to know whether the batteries 302, which have degraded to a state wherein further usage would be problematic (i.e., batteries that have reached the end of their operational life), have reached this state as a result of normal degradation or abnormal degradation. It is also possible to obtain the same diagnostic results using only the second diagnosis that utilizes internal resistance and the number of chargings.

At step S121 of FIG. 20, it is confirmed whether the first diagnosis that utilizes the charging/ discharging capacity and the number of chargings has been performed, and it is confirmed whether the second diagnosis that utilizes internal resistance and the number of chargings has been performed. If both the first diagnosis and the second diagnosis have been performed, the process proceeds to step S123. If both the first diagnosis and the second diagnosis have not been performed, the process proceeds to step S125.

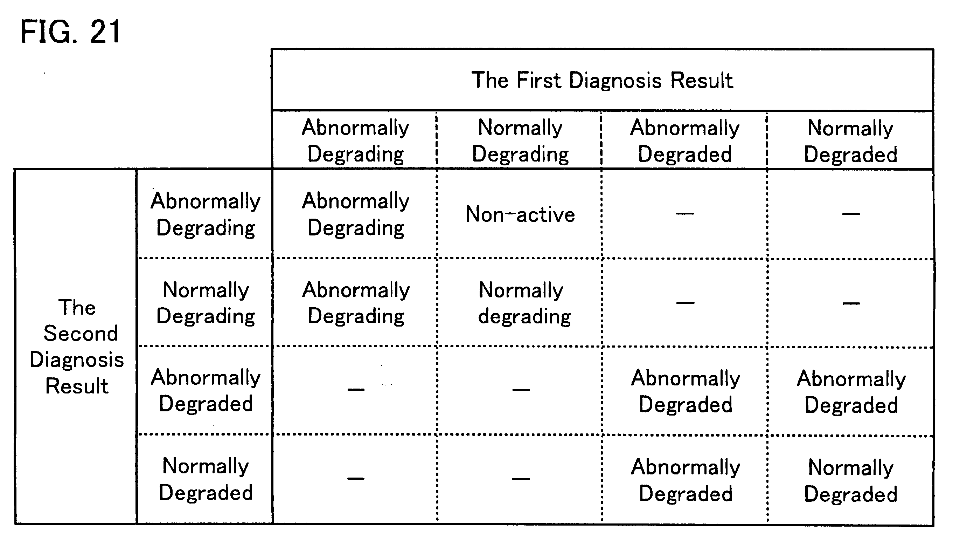

At step S123, a combined diagnosis of the state of the battery 302 is performed utilizing the first diagnostic results and the second diagnostic results. FIG. 21 shows a diagnostic reference of the combined diagnosis. In the combined diagnosis, for example, if the first diagnostic result is 'abnormally degraded' when the second diagnostic result is 'normally degrading', it is diagnosed that the battery 302 is normal but is in a non-active state. By using the combined diagnosis, the battery 302 that is in the non-active state is not misdiagnosed as being in a normal or an abnormal state.

The combined diagnostic reference shown in FIG. 21 combines the reference degradation map 120 relating to the internal resistance of the reference data 330 with the reference degradation map 180 relating to charging/ discharging capacity, thereby forming a three-dimensional map that stores the state of the battery, which map (LUT) comprises capacity, internal resistance, and number of chargings as indices. By performing the combined diagnosis, it is possible to distinguish whether a normal battery is in a normal (active) state or a non-active state.

The results of the combined diagnosis are displayed on the result display portion 326b of the operating panel 326. Similarly, the diagnostic results are displayed by means of illuminating certain LEDs (i.e., LEDs 375 to 378) of the combined diagnosis display portion 373. If the state of degradation of the battery 302 was diagnosed as being 'normally degrading', only the LED 375c is illuminated. If the state of degradation of the battery 302 was diagnosed as being 'abnormally degrading', only the LED 376c is illuminated. If the state of degradation of the battery 302 was diagnosed as being 'normally degraded', only the LED 377c is illuminated. If the state of degradation of the battery 302 was diagnosed as being 'abnormally degraded', both the LED 376c and the LED 377c are illuminated. If the state of the battery 302 was diagnosed as being 'non-active', only the LED 378 is illuminated. The user of the battery diagnosing device 320 is thereby able to know the results of the combined diagnosis.

At step S125, the number of chargings, the charging/ discharging capacity and the internal resistance of the battery 302 that were detected during previous diagnoses of the battery pack 301 are detected. The processing circuit 321 reads the previous diagnostic data 314 stored in the EEPROM 305 of the battery pack 301. When the detected values from previous diagnoses of the battery 302 have been detected, the process proceeds to step S127. When these values have not been detected, the process proceeds to step S129. The detected values from previous diagnoses may, for example, be stored in the battery diagnosing device 320 by means of the personal computer 340 that the user has connected, etc.

At step S127, the number of remaining chargings is estimated utilizing the detected values from previous diagnoses and the detected values from the present diagnosis. The number of remaining chargings may be calculated utilizing a plurality of pairs of data of detected values of charging/ discharging capacity and detected values of the number of chargings. Alternatively, it is possible to utilize a plurality of pairs of data of detected values of internal resistance and detected values of the number of chargings. One or the other of these pluralities of pairs of data will suffice.

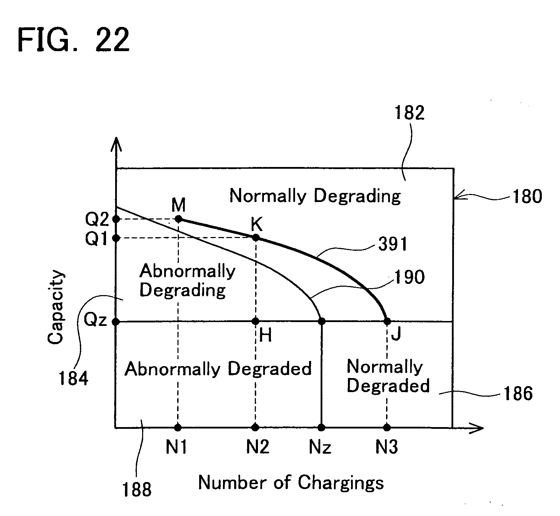

Using FIG. 22, a method will be described for estimating the number of remaining chargings from, for example, two pairs of data of charging/ discharging capacity and number of chargings. The reference degradation map 180 relating to charging/ discharging capacity stored in the reference data 330 is utilized in estimating of the number of remaining chargings. In the reference degradation map 180 relating to charging/ discharging capacity shown in FIG. 22, a point M shows the detected value of charging/ discharging capacity relative to the number of chargings of previous diagnoses of the battery 302. That is, charging/ discharging capacity detected in previous diagnoses is Q2, and the number of chargings detected is N1. Further, the detected value of the charging/ discharging capacity relative to the number of chargings of the present diagnosis is shown by the point K. That is, the charging/ discharging capacity detected in the present diagnosis is Q1, and the number of chargings detected is N2. The processing circuit 321 plots the point M and the point K on the reference degradation map 180 relating to charging/ discharging capacity, and forms a curved line of transitions 391 that passes through the point M and the point K. A point J can be found from the curved line of transitions 391 that was formed, this point J being a point where charging/ discharging capacity becomes the degradation reference capacity value Qz. The number of chargings shown by point J is N3. That is, it is found that the number of chargings when the battery 302 reaches a state in which further utilization is not possible is N3. Since the number of chargings is N2 in the present diagnosis, the number of remaining chargings can be found from the difference between N3 and N2.

By utilizing a plurality of pairs of data of charging/ discharging capacity and number of chargings, it is possible to extrapolate the trend of decreasing charging/ discharging capacity relative to the increase in the number of chargings, and to estimate the number of remaining chargings. The trend of decreasing charging/ discharging capacity relative to the increase in the number of chargings differs according to the manner of use of the battery. Thus, this battery diagnosing device 320 is capable of accurately estimating (predicting) the number of remaining chargings for various manners of using of the battery.

The curved line of transitions 391 can be formed by utilizing a locus building method commonly used in statistics, etc. When there is little detected data, it is possible to form a reliable locus by extrapolating empirical data concerning the quantity (amount) of change in battery capacity relative to the number of chargings, and thereby forming the curved line of transitions 391. In addition, the quantity of change data 332 stored in the memory 323 of the battery diagnosing device 320 may also be utilized.

A case was described above wherein the number of remaining chargings was estimated utilizing a plurality of pairs of data of charging/ discharging capacity relative to the number of chargings. However, estimation based upon internal resistance can be performed in the same manner. That is, it is possible to estimate, in the same manner, the number of remaining chargings utilizing the internal resistance reference degradation map 120.

When the history of previous diagnoses of the battery 302 has not been detected at step S125 and the process proceeds to step S129, a different method is performed to estimate the number of remaining chargings. The estimation of the number of remaining chargings performed at step S129 is approximately the same as the process whereby the battery checking system 2 of Embodiment 1 estimates the degree of progress of degradation. As shown in FIG. 10, the data of internal resistance relative to number of chargings is plotted (point X) on the internal resistance reference degradation map 120, and the quantity of change data 332 is utilized to form the curved line 132 concerning the expected future relationship between the number of chargings and the internal resistance. The number of chargings N3 is found using the curved line of transitions 132, this number of chargings N3 being the time at which internal resistance reaches the degradation reference resistance value Rz, and the number of remaining chargings (the difference between N3 and N2) is calculated.

At this time, the quantity of increase of internal resistance relative to the number of chargings, which is stored in the quantity of change data 332, may be revised in accordance with the history of use detected at step S109. As was described above, the speed of progress of degradation varies according to the manner in which the rechargeable battery is used. That is, the quantity of increase of internal resistance relative to the number of chargings varies according to the manner of use. By revising the quantity of increase of internal resistance relative to the number of chargings in accordance with the history of use, it is possible to accurately estimate the number of remaining chargings for various methods of use of the battery 302.

Above, a case was described wherein the number of remaining chargings was estimated utilizing data of capacity relative to an existing number of chargings. However, a case utilizing internal resistance is performed in the same manner, and the number of remaining chargings can be estimated in the same manner.

At step S131, the number of remaining chargings of the battery 302 found at step S127 or step S129 is displayed on the display portion 326b of the operating panel 326. The number of remaining chargings is displayed as a numerical value on the seven-segment LED 379 of the combined diagnosis display portion 373.

As described above, the battery diagnosing device 320 diagnoses the state of degradation of the battery 302 from the number of chargings and from at least one of the charging/ discharging capacity and the internal resistance of the battery 302. By this means, it is possible to diagnose, in a battery wherein charging/ discharging capacity has fallen (dropped), whether the fall (drop or reduction) in charging/ discharging capacity is consistent with normal degradation or is a result of failure. Further, it is possible to diagnose, in a battery wherein internal resistance has increased, whether the increase in internal resistance is consistent with normal degradation or is a result of failure. Moreover, it is possible to determine whether a battery is in a non-active state by means of diagnosis that utilizes both the capacity and the internal resistance of the battery as well as utilizing the relationship of the two with the actual number of chargings. Consequently, it is possible to accurately determine the number of remaining chargings of the battery.

In the present embodiments, the cumulative number of chargings was chosen to be an indicator of the usage quantity of the rechargeable batteries. However, other indicators of the usage quantity can also be chosen, such as cumulative discharging time, cumulative charging time, cumulative discharging quantity of power, cumulative charging quantity of power, etc. The indicator can be chosen freely to suit the mode of implementation, and the design of the present embodiment can be changed to correspond thereto.

In the present embodiments, internal resistance and the charging/ discharging capacity were chosen to be indicators of the progress of degradation of the rechargeable batteries. However, the indicators are not limited thereto. Indicators that change in accordance with the progress of degradation of the rechargeable batteries can be chosen freely, and the design of the present embodiment can be changed to correspond thereto.

The methods for detecting the number of chargings, internal resistance, charging/discharging capacity, etc. chosen in the present embodiments are merely illustrative examples, and these indicators may also be detected by means of other methods.

The internet is utilized in the battery checking network of the present embodiments. However, other computer networks may also be chosen. Electronic information communication techniques that are yet to be developed can also be chosen.

In the battery checking system of the present embodiments, an example has been chosen wherein an adaptor is attached between the charger and the battery pack 301. However, the invention is not limited to this example. The same type of battery checking system can have a configuration that does not have the charger, etc. connected therewith.

## Claims

1. A battery diagnosing device (2; 320) for determining whether a rechargeable battery (18; 302) has degraded normally or abnormally, comprising:
means (92, 94; 321, 338) for measuring at least one degradation indicator representative of the degradation condition of the rechargeable battery,
means (61, 72; 321) for determining a usage quantity of the rechargeable battery, and
means (72; 321, 334) for comparing the set of the measured degradation indicator and the determined usage quantity with a set of a reference degradation value and a reference usage value.

2. A battery diagnosing device as set forth in claim 1, wherein the comparing means (72; 321, 334) is adapted to compare:
the determined usage quantity with an endpoint reference usage value when the measured degradation indicator has exceeded an endpoint reference degradation value.

3. A battery diagnosing device as set forth in claim 1, wherein a standard relationship, which respectively assigns a plurality of reference degradation values to a plurality of reference usage values, is stored by the battery diagnosing device and the comparing means (72; 321, 334) is adapted to:
select from the standard relationship the reference degradation value assigned to the reference usage value that is equal to the determined usage quantity, and
compare the selected reference degradation value with the measured degradation indicator.

4. A battery diagnosing device as set forth in claim 1, wherein a standard relationship, which respectively assigns a plurality of reference degradation values to a plurality of reference usage values, is stored by the battery diagnosing device and the comparing means (72; 321, 334) is adapted to:
select from the standard relationship the reference usage value assigned to the reference degradation value that is equal to the measured degradation indicator, and
compare the selected reference usage value with the determined usage quantity.

5. A battery diagnosing device as set forth in any one of claims 1 to 4, wherein
the degradation indicator is one or more of:
the internal resistance of the rechargeable battery (18; 302), and/or
the charging/discharging capacity of the rechargeable battery, and
the usage quantity is one or more of:
cumulative discharging time of the rechargeable battery,
cumulative charging time of the rechargeable battery,
cumulative discharged power of the rechargeable battery,
cumulative charged power of the rechargeable battery, and/or
cumulative number of chargings of the rechargeable battery.

6. A battery diagnosing device as set forth in any one of claims 1 to 5, wherein the comparing means (72; 321, 334) is adapted to modify the determined usage quantity, before it is compared with the reference usage value, based upon a detected frequency of occurrence of over discharging and/or overly-rapid charging of the rechargeable battery (18; 302).

7. A battery diagnosing device as set forth in any preceding claim, further comprising:
means (82; 330) for storing at least one reference degradation map (120, 180), wherein the reference degradation map is a two-dimensional map relating a plurality of degradation indicators to a plurality of usage quantities, which map is divided into at least a "battery normally degrading" region and a "battery abnormally degrading" region, and
wherein the comparing means (72; 321, 334) is adapted to determine whether the set of the measured degradation indicator and the determined usage quantity fall within the "battery normally degrading" region or the "battery abnormally degrading" region of the reference degradation map.

8. A battery diagnosing device as set forth in any preceding claim, wherein the measuring means (92, 94; 321, 338) comprises means for measuring a first degradation indicator of the rechargeable battery (18; 302) and means for measuring a second degradation indicator of the rechargeable battery, the battery diagnosing device further comprising:
means (82; 330) for storing a reference activity map (140), wherein the reference activity map is a two-dimensional map relating a plurality of first degradation indicators to a plurality of second degradation indicators, which map is divided into a "battery active" region and a "battery non-active" region,
means (90; 321) for determining whether the set of the measured first degradation indicator and the measured second degradation indicator fall within the "battery active" region or the "battery non-active" region of the reference activity map,
means (62; 325) for performing a refresh operation on the rechargeable battery when the set of the first and second measured degradation indicators have been determined to fall within the battery "non-active" region, and
means (90; 321, 332) for estimating, based upon a plurality of pairs of measured degradation indicators and determined usage quantities, the future remaining usage quantity that indicates how much the rechargeable battery may be further used until the measured degradation indicator will exceed the endpoint reference degradation value.

9. A battery diagnosing device (2; 320) for estimating a future remaining usage quantity of a rechargeable battery (18; 302), comprising:
means (92, 94; 321, 338) for measuring at least one degradation indicator representative of a degradation condition of the rechargeable battery,
means (61, 72; 321) for determining a usage quantity of the rechargeable battery,
means (86; 314) for accumulating and storing a plurality of pairs of measured degradation indicators and determined usage quantities, and
means (90; 321, 332) for estimating, based upon the stored plurality of pairs of measured degradation indicators and determined usage quantities, the future remaining usage quantity that indicates how much the rechargeable battery may be further used until the measured degradation indicator will exceed a predetermined level.

10. A battery diagnosing device (2; 320) for estimating a future remaining usage quantity of a rechargeable battery (18; 302), comprising:
means (92, 94; 321, 338) for measuring at least one degradation indicator representative of a degradation condition of the rechargeable battery,
means (61, 72; 321) for determining a usage quantity of the rechargeable battery,
means (82; 330) for storing a standard relationship between a plurality of degradation indicators and usage quantities, and
means (90; 321, 332) for estimating, based upon the measured degradation indicator, the determined usage quantity and the standard relationship, the future remaining usage quantity that indicates how much the rechargeable battery may be further used until the measured degradation indicator will exceed a predetermined level.

11. A battery diagnosing device (2; 320) for determining whether a rechargeable battery (18; 302) is in an active state or a non-active state, comprising:
means (92, 94; 321, 338) for measuring a first degradation indicator representative of a degradation condition of the rechargeable battery,
means (92, 94; 321, 338) for measuring a second degradation indicator representative of a degradation condition of the rechargeable battery,
means (82; 330) for storing a reference activity map (140), wherein the reference activity map is a two-dimensional map relating a plurality of first degradation indicators to a plurality of second degradation indicators, which map is divided into a "battery active" region and a "battery non-active" region, and
means (90; 321) for determining whether the set of the measured first degradation indicator and the measured second degradation indicator fall within the "battery active" region or the "battery non-active" region of the reference activity map.

12. A battery diagnosing device as set forth in claim 11, wherein
the first degradation indicator is a detected internal resistance of the rechargeable battery (18; 302), and
the second degradation indicator is a detected charging/discharging capacity of the rechargeable battery.

13. A battery diagnosing device as set forth in claim 11 or 12, further comprising means (62; 325) for discharging current from the rechargeable battery (18; 302) when the determining means (90; 321) determines that the set of the measured first and second degradation indicators fall within the "battery non-active" region of the reference activity map (140), thereby indicating that the rechargeable battery requires a refresh operation.

14. A diagnostic information collecting system (200), comprising:
a plurality of battery checking sub-systems (2; 320) for diagnosing rechargeable batteries (18; 302) and obtaining diagnostic information therefrom,
an information accumulating device (212, 214, 216; 340) for accumulating and storing the diagnostic information, and
a communication means (96; 226) for connecting the plurality of battery checking sub-systems to the information accumulating device via a network (204), wherein the communication means is adapted to transmit the diagnostic information obtained by the battery checking sub-systems to the information accumulating device.

15. A diagnostic information collecting system (200) as set forth in claim 14, further comprising a reference value calculating means (224) adapted to extract a relationship between a determined usage quantity and one or more measured degradation indicators from the diagnostic information accumulated by and stored in the information accumulating device (212, 214, 216; 340), and to calculate at least one reference value concerning the degradation indicator and the usage quantity.

16. An apparatus (50; 320) adapted to be interposed between a battery charging device (30; 350) and a rechargeable battery (18; 302), comprising:
means (325) for conducting a charging current from the battery charging device to the rechargeable battery,
a circuit (62; 325) adapted to discharge current from the rechargeable battery,
a selecting circuit (68; 321) adapted to select either the conducting means or the discharging circuit to function, and
means (61, 65; 321) for switching the selecting circuit, such that the discharging circuit functions to discharge current from the rechargeable battery when measured first and second degradation indicators of the condition of the rechargeable battery indicate that the rechargeable battery requires a refresh operation.

17. A battery diagnosing method for determining whether a rechargeable battery (18; 302) has degraded normally or abnormally, comprising:
measuring (S6, S8; S113, S 117) at least one degradation indicator representative of the degradation condition of the rechargeable battery,
determining (S4; S107, S109) a usage quantity of the rechargeable battery, and
comparing (S16; S 115, S 119) the set of the measured degradation indicator and determined usage quantity with a set of a reference degradation value and a reference usage value.

18. A battery diagnosing method as set forth in claim 17, wherein the comparing step (S16; S115, S119) further comprises:
comparing the determined usage quantity with an endpoint reference usage value when the measured degradation indicator has exceeded an endpoint reference degradation value.

19. A battery diagnosing method as set forth in claim 17, wherein the comparing step (S16; S115, S 119) further comprises:
selecting from a standard relationship the reference degradation value assigned to the reference usage value that is equal to the determined usage quantity, wherein the standard relationship respectively assigns a plurality of reference degradation values to a plurality of reference usage values, and
comparing the selected reference degradation value with the measured degradation indicator.

20. A battery diagnosing method as set forth in claim 17, wherein the comparing step (S16; S 115, S 119) further comprises:
selecting from a standard relationship the reference usage value assigned to the reference degradation value that is equal to the measured degradation indicator, wherein the standard relationship respectively assigns a plurality of reference degradation values to a plurality of reference usage values, and
comparing the selected reference usage quantity with the determined usage quantity.

21. A battery diagnosing method as defined in claim 17, wherein the comparing step (S16; S115, S119) further comprises:
determining whether the set of the measured degradation indicator and the determined usage quantity fall within a "battery normally degrading" region or a "battery abnormally degrading" region of a stored reference degradation map (120, 180), wherein the reference degradation map is a two-dimensional map relating a plurality of degradation indicators to a plurality of usage quantities, which map is divided into the "battery normally degrading" region and the "battery abnormally degrading" region.

22. A battery diagnosing method as defined in any one of claims 17-21, wherein the measuring step (S6, S8; S 113, S117) comprises:
measuring (S6, S8; S 113, S 117) a first degradation indicator representative of the degradation condition of the rechargeable battery (18; 302),
measuring (S6, S8; S 113, S 117) a second degradation indicator representative of the degradation condition of the rechargeable battery, and
the method further comprises:
determining (S10, S12; S123) whether the set of the measured first degradation indicator and the measured second degradation indicator fall within a "battery active" region or a "battery non-active" region of a reference activity map (140), wherein the reference activity map is a two-dimensional map relating a plurality of first degradation indicators to a plurality of second degradation indicators, which map is divided into the "battery active" region and the "battery non-active" region,
performing a refresh operation on the rechargeable battery when the set of the first and second measured degradation indicators have been determined to fall within the battery "non-active" region, and
estimating (S127, S129), based upon a stored plurality of pairs of measured degradation indicators and determined usage quantities, the future remaining usage quantity that indicates how much the rechargeable battery may be further used until the measured degradation indicator will exceed the endpoint reference degradation value.

23. A battery diagnosing method for estimating a future usage quantity of a rechargeable battery (18; 302), comprising:
measuring (S6, S8; S113, S 117) at least one indicator representative of a degradation condition of the rechargeable battery,
determining (S4; S107, S109) a usage quantity of the rechargeable battery,
accumulating and storing a plurality of pairs of measured degradation indicators and determined usage quantities, and
estimating (S127, S129), based upon the stored plurality of pairs of measured degradation indicators and determined usage quantities, the future remaining usage quantity that indicates how much the rechargeable battery may be further used until the measured degradation indicator will exceed a predetermined level.

24. A battery diagnosing method for estimating a future usage quantity of a rechargeable battery (18; 302), comprising:
measuring (S6, S8; S113, S 117) at least one indicator representative of a degradation condition of the rechargeable battery,
determining (S4; S107) a usage quantity of the rechargeable battery, and
estimating (S127), based upon the measured degradation indicator, the determined usage quantity and a standard relationship between a plurality of degradation indicators and usage quantities, the future remaining usage quantity that indicates how much the rechargeable battery may be further used until the measured degradation indicator will exceed a predetermined level.

25. A battery diagnosing method for determining whether a rechargeable battery (18; 302) is in an active state or a non-active state, comprising:
measuring (S6, S8; S113, S 117) a first degradation indicator representative of the degradation condition of the rechargeable battery,
measuring (S6, S8; S113, S 117) a second degradation indicator representative of the degradation condition of the rechargeable battery, and
determining (S10, S12; S123) whether the set of the measured first degradation indicator and the measured second degradation indicator fall within a "battery active" region or a "battery non-active" region of a reference activity map (140), wherein the reference activity map is a two-dimensional map relating a plurality of first degradation indicators to a plurality of second degradation indicators, which map is divided into the "battery active" region and the "battery non-active" region.

26. A battery diagnosing method as set forth in claim 25, further comprising:
performing a refresh operation (S32) on the rechargeable battery (18; 302) when it is determined that the set of the measured first and second degradation indicators fall within the "battery non-active" region of the reference activity map (140).
